(19) Europäisches Patentamt
European Patent Office
Office européen des brevets

(11) **EP 1 950 794 A1**

(12) **EUROPEAN PATENT APPLICATION**
published in accordance with Art. 158(3) EPC

(43) Date of publication:
**30.07.2008 Bulletin 2008/31**

(51) Int Cl.:
**H01L 21/027** (2006.01) **G03F 7/207** (2006.01)

(21) Application number: **06811544.3**

(22) Date of filing: **10.10.2006**

(86) International application number:
**PCT/JP2006/320232**

(87) International publication number:
**WO 2007/043535 (19.04.2007 Gazette 2007/16)**

(84) Designated Contracting States:
**AT BE BG CH CY CZ DE DK EE ES FI FR GB GR HU IE IS IT LI LT LU LV MC NL PL PT RO SE SI SK TR**

(30) Priority: **07.10.2005 JP 2005294858**

(71) Applicant: **NIKON CORPORATION Tokyo 100-8331 (JP)**

(72) Inventor: **MIYASHITA, Kazuyuki Tokyo 100-8331 (JP)**

(74) Representative: **HOFFMANN EITLE Patent- und Rechtsanwälte Arabellastrasse 4 81925 München (DE)**

(54) **OPTICAL CHARACTERISTIC MEASURING METHOD, EXPOSURE METHOD, DEVICE MANUFACTURING METHOD, INSPECTING APPARATUS AND MEASURING METHOD**

(57) For a plurality of divided areas on a wafer that is exposed by generating measurement pattern images, a predetermined statistic that includes the deviation of the luminance value of each pixel included in imaging data obtained by the imaging with respect to a predetermined reference value is computed, for example, the variance is computed, and optical characteristics of a projection optical system are obtained based on a computation result of the computed statistic of each of the divided areas (steps 504, 506, 512 and 514). Therefore, the optical characteristics can be measured with good repeatability even by a measurement device such as a microscope having a lower resolution compared with the SEM or the like, for example, an alignment sensor by an image-forming method of an exposure apparatus or the like.

*Fig. 8*

426

```
START
  ↓
POSITION SETTING TO EVALUATION–POINT–CORRESPONDING AREA DBn     502
  ↓
CAPTURE IMAGING DATA     504
  ↓
CREATE IMAGING DATA FILE     506
  ↓
DETECT THE OUTER EDGE OF EVALUATION–POINT–CORRESPONDING AREA DBn     508
  ↓
COMPUTE EACH DIVIDED AREA WITH REFERENCE TO THE OUTER EDGE     510
  ↓
COMPUTE THE CONTRAST VALUE PER MEASUREMENT MARK AREA OF EACH DIVIDED AREA     512
  ↓
COMPUTE THE BEST FOCUS POSITION     514
  ↓
PROCESSING OF ALL EVALUATION–POINT–CORRESPONDING AREAS ENDS?     516
  N → n←n+1 (518) → (back to START)
  Y ↓
COMPUTE OPTICAL CHARACTERISTICS     520
  ↓
RETURN
```

EP 1 950 794 A1

# Description

The present invention relates to optical characteristics measurement methods, exposure methods and device manufacturing methods, and more specifically, to an optical characteristics measurement method of measuring optical characteristics of an optical system that generates a pattern image on a predetermined surface, an exposure method of performing exposure taking the optical characteristics measured by the optical characteristics measurement method into consideration and a device manufacturing method making use of the exposure method, and an inspection apparatus that detects a plurality of patterns formed on a substrate and a measurement method that can be suitably performed using the inspection apparatus.

The integration of semiconductor devices (integrated circuits) and the like is getting higher year by year, and accordingly the much higher resolving power is being required for a projection exposure apparatus, such as a stepper, that is a manufacturing apparatus of semiconductor devices and the like. In order to improve the resolving power of the projection exposure apparatus, the optical performance of a projection optical system needs to be improved. Therefore, it is important to accurately measure and evaluate optical characteristics (including image-forming characteristics) of the projection optical system.

Accurate measurement of the optical characteristics of the projection optical system, for example, accurate measurement of an image plane of a pattern can be performed based on the assumption that a best focus position at each evaluation point (measurement point) within a field of the projection optical system can accurately be measured.

As a conventional measurement method of the best focus position of the projection optical system, a so-called CD (Critical Dimension)/Focus method is representatively known. In this method, a predetermined reticle pattern (such as a line-and-space pattern) serves as a test pattern and the test pattern is transferred to a test wafer at a plurality of positions in an optical axis direction of the projection optical system. Then, a linewidth value of a resist image (an image of the transferred pattern) that is obtained by developing the test wafer is measured using the scanning electron microscope (SEM) or the like, and the best focus position is computed based on a relation between the linewidth value and the wafer position in the optical axis direction of the projection optical system (hereinafter, also referred to as a "focus position").

Besides, a so-called SMP focus measurement method that is disclosed in Patent Document 1 and the like is also known. In this method, a resist image of a wedge-shaped mark is formed on a wafer at a plurality of focus positions, and the length of the resist image in the longitudinal direction (which is the amplification of the change in the linewidth value of the resist image due to the difference in the focus position) is measured using a mark detection system such as an alignment system. Then, based on a relation between the focus position and the length of the resist image, the best focus position is computed.

However, in the CD/Focus method described above, the focusing of the SEM needs to be performed strictly in order to measure, for example, the linewidth value of the resist image by the SEM, and therefore it takes a very long time to perform the measurement at one point and several hours to several tens of hours were necessary for performing the measurement at many points. Further, it is expected that a test pattern used to measure the optical characteristics of the projection optical system becomes finer and also the number of evaluation points within the field of the projection optical system increases. Accordingly, with the conventional measurement method using the SEM, the throughput until the measurement results can be obtained drastically decreases. Further, the higher level is required also for repeatability of measurement errors or measurement results and therefore it becomes difficult to cope with it by the conventional measurement method.

Meanwhile, in the SMP focus measurement method described above, since the measurement is usually performed using a monochromatic light, the effect of interference differs depending on the difference in shape of a resist image, which may lead to measurement error (dimension offset). Further, the resolution of the current image-capturing instrument (such as a CCD camera) is still insufficient for performing length measurement of the resist image of the wedge-shaped mark in the image processing. In addition, it was difficult to increase the number of evaluation points because the test pattern is large in size.

Patent Document 1: U.S. Patent No. 4,908,656

The present invention has been made in consideration of the situation described above, and according to a first aspect of the present invention, there is provided a first optical characteristics measurement method of measuring an optical characteristic of an optical system that generates a pattern image on a predetermined surface, the method comprising: a first process of sequentially exposing a plurality of divided areas on an object that is placed on the predetermined surface side of the optical system, by generating a measurement pattern image within an exposure area of the optical system while changing a position of the object in an optical axis direction of the optical system; a second process of imaging the plurality of divided areas on the object; and a third process of computing a predetermined statistic related to a luminance value of each pixel for each of the divided areas by processing imaging data obtained by the imaging, and also obtaining an optical characteristic of the optical system based on the computed statistic regarding each of the divided areas.

With this method, for a plurality of divided areas on an object that is exposed by generating a measurement pattern image, a predetermined statistic related to a luminance value of each pixel included in imaging data obtained by the imaging is computed, and based on the computed statistic regarding each of the areas, the optical characteristics of the optical system are obtained. Therefore, even when the measurement pattern image of each divided area is a set of a plurality of pattern images, since the set of a plurality of pattern images is consequently considered as one pattern image, even a measurement device such as a microscope having a low resolution, for example, an alignment sensor by an image-forming method of an exposure apparatus and the like can perform the measurement. Regardless of the types of pattern images (such as a line-and-space (an isolated line, a dense line), a contact hole, the size and the disposed direction) and regardless of illumination conditions when generating the pattern images, the measurement can be performed.

According to a second aspect of the present invention, there is provided a first exposure method, comprising: a process of measuring an optical characteristic of an optical system using the first optical characteristics measurement method of the present invention; and a process of exposing an object by generating a predetermined pattern image within an exposure area of the optical system, taking a measurement result of the optical characteristic into consideration.

With this method, regardless of the types of pattern images and regardless of illumination conditions when generating the pattern images, the optical characteristics of the optical system are measured with high accuracy using the first optical characteristics measurement method, and an object is exposed by generating a predetermined pattern image within an exposure area of the optical system taking measurement results of the optical characteristics into consideration. Accordingly, the generation of the pattern image on the object with high accuracy, that is, the highly accurate exposure is realized.

According to a third aspect of the present invention, there is provided a second optical characteristics measurement method of measuring an optical characteristic of an optical system that is used in an exposure apparatus that generates a pattern image on an object via the optical system and liquid, the method comprising: a first process of sequentially exposing a plurality of divided areas on the object, by sequentially moving the object in a predetermined step pitch long enough to keep temperature variation of the liquid caused by exposure of a previous shot area from affecting exposure of a next shot area, and generating a measurement pattern image within an exposure area of the optical system, while changing at least one exposure condition; a second process of detecting a forming state of the measurement pattern image in the plurality of divided areas on the object; and a third process of obtaining an optical characteristic of the optical system based on a result of the detection.

With this method, a plurality of divided areas on an object are sequentially exposed, by sequentially moving the object in a predetermined step pitch long enough to keep temperature variation of the liquid caused by exposure of a previous shot area from affecting exposure of a next shot area, and generating a measurement pattern image within an exposure area of the optical system, while changing at least one exposure condition. Therefore, the temperature stability of liquid can favorably be maintained when exposing each shot. With this operation, the measurement pattern image can be formed with high accuracy in a plurality of divided areas on the object, a forming state of the measurement pattern image is detected, and the optical characteristics of the optical system can be obtained based on the detection result.

According to a fourth aspect of the present invention, there is provided a second exposure method, comprising: a process of measuring an optical characteristic of the optical system using the second optical characteristics measurement method of the present invention; and a process of exposing the object with a predetermined pattern image formed via the optical system and liquid, taking a measurement result of the optical characteristic into consideration.

With this method, the optical characteristics of the optical system are measured with high accuracy using the second optical characteristics measurement method, and the object is exposed with a predetermined pattern image formed via the optical system and liquid taking measurement results of the optical characteristics into consideration. Accordingly, the generation of the pattern image on the object with high accuracy by exposure using the optical system and liquid is realized.

In the lithography process, the productivity (including the yield) of microdevices can be improved by exposing an object by either the first or second exposure method of the present invention. Accordingly, it can also be said that according to a fifth aspect of the present invention, there is provided a device manufacturing method, including a lithography process of exposing an object by either the first or second exposure method of the present invention.

According to a sixth aspect of the present invention, there is provided an inspection apparatus that detects a plurality of pattern images that are formed on a substrate via an optical system respectively under a different exposure condition, the apparatus comprising: an imaging device that has a field capable of simultaneously imaging the plurality of pattern images; and a processor that computes contrast information of the plurality of pattern images using imaging data of the plurality of pattern images by the imaging device and also obtains a proper value of the exposure condition based on the contrast information.

With this apparatus, since the proper value of the exposure condition is obtained based on the contrast information, the strict focusing as in the case of performing linewidth measurement using the SEM becomes unnecessary, which can shorten the measurement time.

According to a seventh aspect of the present invention, there is provided a measurement method of performing a predetermined measurement by detecting a plurality of pattern images that are formed on a substrate respectively under a different exposure condition via an optical system, the method comprising: a process of imaging the plurality of pattern images using an imaging device that has a field capable of simultaneously imaging the plurality of pattern images; and a process of computing contrast information of the plurality of pattern images using imaging data of the imaged plurality of pattern images, and also obtaining a proper value of the exposure condition based on the contrast information.

With this method, since the proper value of the exposure condition is obtained based on the contrast information, the strict focusing as in the case of performing linewidth measurement using the SEM becomes unnecessary, which can shorten the measurement time.

According to an eighth aspect of the present invention, there is provided a best focus measurement method of a projection exposure apparatus, the method comprising: a process of forming a plurality of images of pattern areas each including a pattern having a linewidth that is less than or equal to around four times a resolution limit of the projection exposure apparatus respectively at different positions on an object, while changing a focus position; a process of detecting brightness/darkness information of the plurality of images of pattern areas formed on the object, using an inspection optical system whose resolution limit is more than a quarter of the resolution limit of the projection exposure apparatus; and a process of computing a best focus position based on the detected brightness/darkness information.

According to a ninth aspect of the present invention, there is provided a pattern information determining method, comprising: a process of detecting brightness/darkness information of a pattern group, in which a plurality of pattern areas each including a periodic pattern that is less than or equal to a resolution limit of an inspection optical system are formed, using the inspection optical system; and a process of determining a pattern area with which a change in the detected brightness/darkness information becomes maximum from among the pattern group.

According to a tenth aspect of the present invention, there is provided a pattern information determining apparatus, comprising: an inspection optical system that detects brightness/darkness information of a pattern group in which a plurality of pattern areas each including a periodic pattern are formed; and a processor that determines a pattern area with which a change of the detected brightness/darkness information becomes maximum from among the pattern group, wherein the periodic pattern is less than or equal to a resolution limit of the inspection optical system.

FIG. 1 is a view showing the schematic configuration of an exposure apparatus related to a first embodiment.

FIG. 2 is a view showing an example of a reticle used in measurement of optical characteristics of a projection optical system.

FIG. 3 is a view showing the configuration of a measurement pattern MPn.

FIG. 4 is a flowchart used to explain a measurement method of the optical characteristics related to the first embodiment.

FIG. 5 is a view used to explain the arrangement of divided areas.

FIG. 6 is a view showing a state in which evaluation-point-corresponding areas DB1 to DB5 are formed on a wafer WT.

FIG. 7 is a view showing an example of a resist image of evaluation-point-corresponding area DB1 formed on wafer WT after developing wafer WT.

FIG. 8 is flowchart showing details of step 426 (computation processing of the optical characteristics) in FIG. 4.

FIG. 9 is a view used to explain a way to obtain a best focus position.

FIG. 10 is a view showing a pattern having three lines and two spaces that are obtained by dividing a line having a linewidth of $0.4\mu m$ (the reduced value on the wafer) into five, as an example of a measurement pattern.

FIG. 11 is a view showing the schematic configuration of an exposure apparatus related to a second embodiment.

FIG. 12 is a view showing a state in which transferred images of measurement patterns MPn are formed in a plurality of shot areas on wafer WT.

FIG. 13 is a view showing the schematic configuration of an example of an inspection apparatus related to a third embodiment.

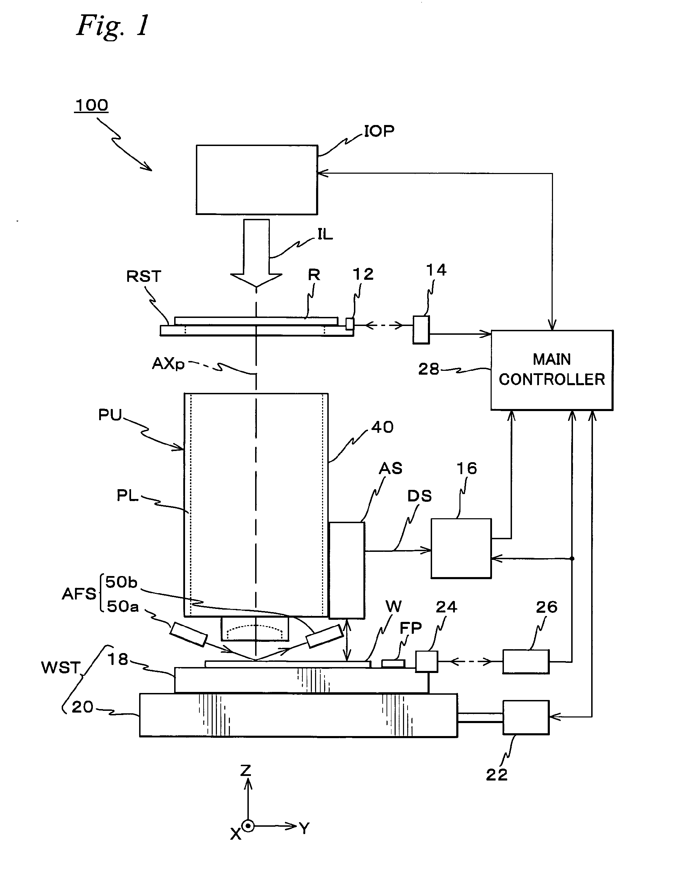

A first embodiment of the present invention will be described below, referring to FIGS. 1 to 9.

FIG. 1 shows the schematic configuration of an exposure apparatus 100 that is suitable to carry out an optical characteristics measurement method and an exposure method related to the first embodiment. Exposure apparatus 100 is a reduced projection exposure apparatus by a step-and-scan method (a so-called scanning stepper (which is also called a scanner)).

Exposure apparatus 100 is equipped with an illumination system IOP, a reticle stage RST that holds a reticle R, a projection unit PU that projects an image of a pattern formed on reticle R onto a wafer W that is coated with a photosensitive agent (a photoresist), a wafer stage WST that moves within a two-dimensional plane (an XY plane) holding wafer W, a drive system 22 that drives wafer stage WST, their control system and the like. The control system is mainly configured of a main controller 28 that is composed of a microcomputer (or a workstation) that performs the overall control of the entire apparatus and the like.

Illumination system IOP includes a light source that is made up of an ArF excimer laser (output wavelength: 193nm) (or a KrF excimer laser (output wavelength: 248nm), or the like), an illumination system housing that is connected to the light source via a light-transmitting optical system, and an illumination optical system inside the illumination system housing. The illumination optical system includes an illuminance uniformity optical system including an optical integrator or the like, a beam splitter, a relay lens, a variable ND filter, a reticle blind and the like (none of which are shown), as is disclosed in, for example, Kokai (Japanese Unexamined Patent Application Publication) No. 2001-313250 and the corresponding U.S. Patent Application Publication No. 2003/0025890, and the like. The illumination optical system shapes a laser beam output from the light source and illuminates the shaped laser beam (hereinafter, also referred to as an illumination light) IL to an illumination area having a slit-like shape elongated in an X-axis direction (an orthogonal direction to the page surface of FIG. 1) on reticle R with substantially uniform illuminance.

Reticle stage RST is placed below illumination system IOP in FIG. 1. Reticle R is mounted on reticle stage RST and held by suction via vacuum chuck or the like (not shown). Reticle stage RST is finely drivable within a horizontal plane (the XY plane) and also is scanned in a predetermined stroke range in a scanning direction (which is to be a Y-axis direction that is a horizontal direction in the page surface of FIG. 1 in this case) by a reticle stage drive system (not shown). The position of reticle stage RST is measured by a laser interferometer 14, which is externally placed, via a movable mirror (or an end surface that is mirror finished) 12, and measurement values of laser interferometer 14 are supplied to main controller 28.

Projection unit PU is placed below reticle stage RST in FIG. 1, and includes a barrel 40 and a projection optical system PL that is composed of a plurality of optical elements held in a predetermined positional relation inside barrel 40. As projection optical system PL, a both-side telecentric reduction system, which is a dioptric system composed of a plurality of lens elements (omitted in the drawing) having a common optical axis AXp in a Z-axis direction, is used. Out of the lens elements, at least one lens element is controlled by an image-forming characteristics correction controller (not shown) based on commands from main controller 28, so that optical characteristics (including image-forming characteristics) of projection optical system PL such as the magnification, distortion, comma and curvature of field are adjusted.

The projection magnification of projection optical system PL is to be a quarter, as an example. Therefore, when reticle R is illuminated by illumination light IL with uniform illuminance as is described above, a pattern of reticle R within the illumination area is reduced by projection optical system PL and projected on wafer W which is coated with a photoresist, and a reduced image of the pattern is formed on a part of an area to be exposed (a shot area) on wafer W. On this operation, projection optical system PL forms the reduced image in a partial area within its field (i.e. an exposure area that is a rectangular area conjugate with the illumination area with respect to projection optical system PL). Incidentally, the image-forming characteristics correction controller described above is to move at least one optical element (lens element or the like) of projection optical system PL in order to adjust the optical characteristics of projection optical system PL, that is, the image-forming state of a pattern image on wafer W, but instead of or in combination with the movement, for example, at least one of the change in characteristics (such as the center wavelength, or the spectral width) of illumination light IL by control of the light source, and the movement of wafer W in the Z-axis direction parallel to optical axis AXp of projection optical system PL (and inclination with respect to the XY plane) may be performed.

Wafer stage WST is driven by drive system 22 including a linear motor or the like, and equipped with an XY stage 20 that moves within the XY plane and a wafer table 18 that is mounted on XY stage 20. Wafer W is held on wafer table 18 via a wafer holder by vacuum suction or the like. Wafer table 18 finely drives the wafer holder holding wafer W in the Z-axis direction and an inclination direction with respect to the XY plane, and is also called a Z-tilt stage. A movable mirror (or a reflection surface that is mirror finished) 24 is arranged on the upper surface of wafer table 18, and a laser beam (a measurement beam) from a laser interferometer 26 is projected to movable mirror 24, and based on a reflected light from movable mirror 24, positional information within the XY plane and rotational information (including yawing (a $\theta z$ rotation being a rotation around the Z-axis), pitching (a $\theta x$ rotation being a rotation around the X-axis), and rolling (a $\theta y$ rotation being a rotation around the Y-axis)) of wafer table 18 are measured.

Measurement values of laser interferometer 26 are supplied to main controller 28, and main controller 28 controls the position of wafer table 18 within the XY plane (including the $\theta z$ rotation) by controlling XY stage 20 of wafer stage WST via drive system 22 based on the measurement values of laser interferometer 26.

Further, the position in the Z-axis direction and the inclination amount of a surface of wafer W are measured by a focus sensor AFS that is composed of a multipoint focal point position detection system by an oblique incident method that has a light-transmitting system 50a and a photodetection system 50b, which is disclosed in, for example, Kokai (Japanese Unexamined Patent Application Publication) No. 06-283403 and the corresponding U.S. Patent No. 5,448,332, and the like. Measurement values of focus sensor AFS are also supplied to main controller 28.

Further, a fiducial plate FP whose surface is set to be the same in height as the surface of wafer W is fixed on wafer table 18. On the surface of fiducial plate FP, fiducial marks used in a so-called baseline measurement and the like by an alignment detection system AS (to be described next) and the like are formed.

In the present embodiment, alignment detection system AS that detects alignment marks on wafer W is arranged on the side surface of barrel 40 of projection unit PU. As alignment detection system AS, an FIA (Field Image Alignment) system is used as an example, which is a type of image-forming alignment sensor by an image processing method that illuminates a broadband light such as a halogen lamp to a mark, and measures the mark position by performing the image processing of the mark image. The resolution limit of alignment detection system AS is larger than the resolution limit of projection optical system PL (i.e. the resolution is lower than that of projection optical system PL).

A detection signal DS of alignment detection system AS is supplied to an alignment controller 16, and alignment controller 16 performs A/D conversion of detection signal DS, and detects the mark position by performing arithmetic processing of the digitalized waveform signal. This result is supplied from alignment controller 16 to main controller 28.

Moreover, although omitted in the drawing, in exposure apparatus 100 of the present embodiment, a pair of reticle alignment detection systems each of which is composed of a TTR (Through The Reticle) alignment system that uses a light having the exposure wavelength, which is disclosed in, for example, Kokai (Japanese Unexamined Patent Application Publication) No. 07-176468 and the corresponding U.S. Patent 5, 646, 413, are arranged above reticle R, and detection signals of the reticle alignment detection systems are supplied to main controller 28 via alignment controller 16.

Next, an example of a reticle that is used to measure the optical characteristics of the projection optical system in exposure apparatus 100 will be described.

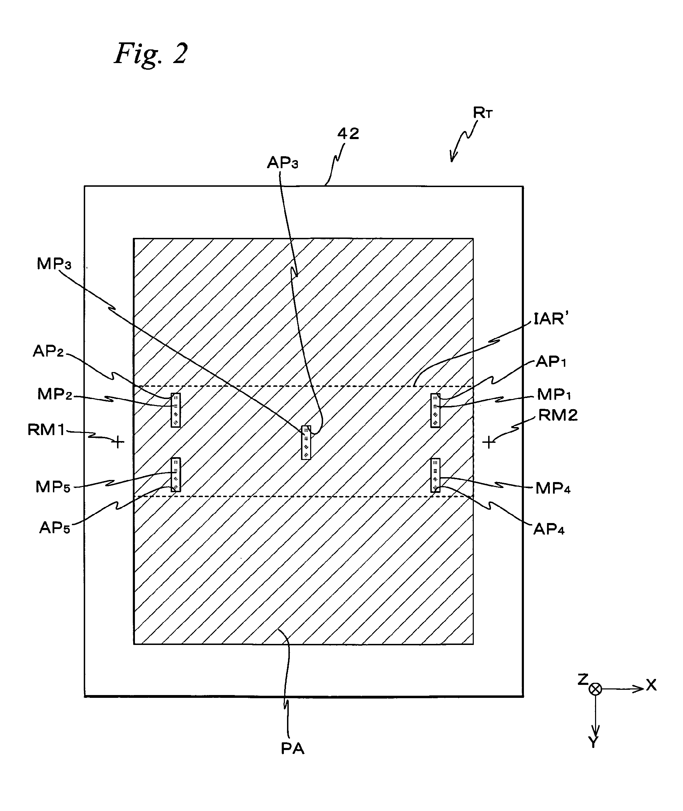

FIG. 2 shows an example of a reticle $R_T$ that is used to measure the optical characteristics of the projection optical system. FIG. 2 is a plan view of reticle $R_T$ being viewed from the side of a pattern surface (the lower surface side in FIG. 1) . As is shown in FIG. 2, reticle $R_T$ is composed of a glass substrate 42 having a rectangular shape (to be accurate, a square shape), and on its pattern surface, a pattern area PA having a substantially rectangular shape that is defined by a light-shielding zone (not shown) is formed. In this example, the substantially entire surface of pattern area PA is made to be a light-shielding section by a light-shielding member such as chromium or the like. At five locations in total, which are the center of pattern area PA (which coincides with the center of reticle $R_T$ (the reticle center) in this case), and four corner portions inside a virtual rectangular area IAR' whose center is on the reticle center and whose longitudinal direction is the X-axis direction, aperture patterns (transmitting areas) $AP_1$ to $AP_5$ each having a predetermined width, e.g. $27\mu$m, and a predetermined length, e.g. $108\mu$m are severally formed, and measurement patterns $MP_1$ to $MP_5$ are formed in aperture patterns $AP_1$ to $AP_5$

respectively. Rectangular area IAR' substantially coincides with the illumination area described above in size and shape. Incidentally, the substantially entire surface of pattern area PA is a light-shielding section in this example (the example in FIG. 2), but since both ends of rectangular area IAR' in the X-axis direction are defined by the light-shielding zone referred to above, a light-shielding section having a predetermined width (e.g. the same width as the light-shielding zone) may only be arranged at both ends of rectangular area IAR' in the Y-axis direction respectively.

Each of measurement patterns $MP_n$ (n=1 to 5) includes four types of line-and-space patterns (hereinafter, described as "L/S patterns") $LS_{vn}$, $LS_{Hn}$, $LS_{Rn}$ and $LS_{Ln}$. Each of L/S patterns $LS_{vn}$, $LS_{Hn}$, $LS_{Rn}$ and $LS_{Ln}$ is configured of a multi-bar pattern in which three line patters each having a predetermined width, e.g. $1.6\mu$m, and a predetermined length, e.g. $9\mu$m, are disposed in a predetermined pitch, e.g. $3.2\mu$m in each periodic direction. In this case, the periodic directions of L/S patterns $LS_{vn}$, $LS_{Hn}$, $LS_{Rn}$ and $LS_{Ln}$ are the X-axis direction, the Y-axis direction, a direction angled at +45 degrees with respect to the Y-axis and a direction angled at -45 degrees with respect to the Y-axis, respectively.

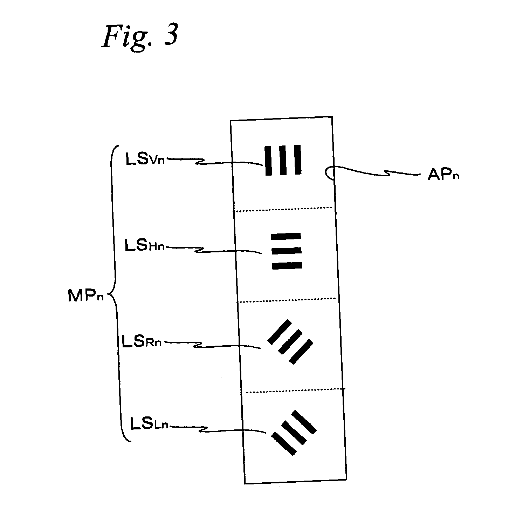

In the present embodiment, in a square-shaped area ($27\mu$m x $27\mu$m) that is a quadrisection of aperture pattern $AP_n$ and enclosed by solid lines and (a) dotted line(s) shown in FIG. 3, L/S patterns $LS_{Vn}$, $LS_{Hn}$, $LS_{Rn}$ and $LS_{Ln}$ are placed respectively with their centers coinciding with the centers of the respective square-shaped areas. Incidentally, the boundaries indicated by dotted lines between the square-shaped areas do not actually exist.

Further, on both sides of pattern area PA in the X-axis direction that passes through the reticle center described above, a pair of reticle alignment marks RM1 and RM2 are formed (refer to FIG. 2).

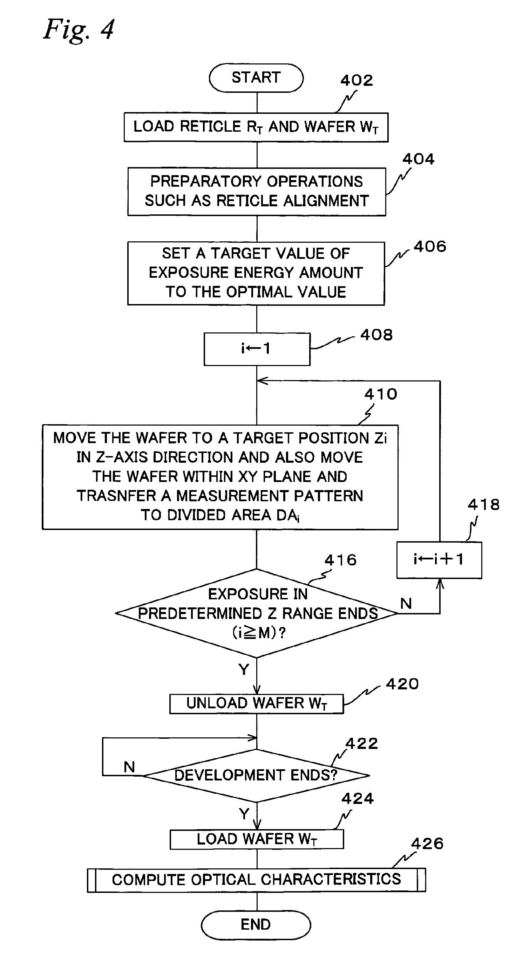

Next, a measurement method of the optical characteristics of projection optical system PL in exposure apparatus 100 of the present embodiment will be described according to a flowchart in FIG. 4 that shows a simplified processing algorithm of a CPU within main controller 28, and also by using other drawings as needed.

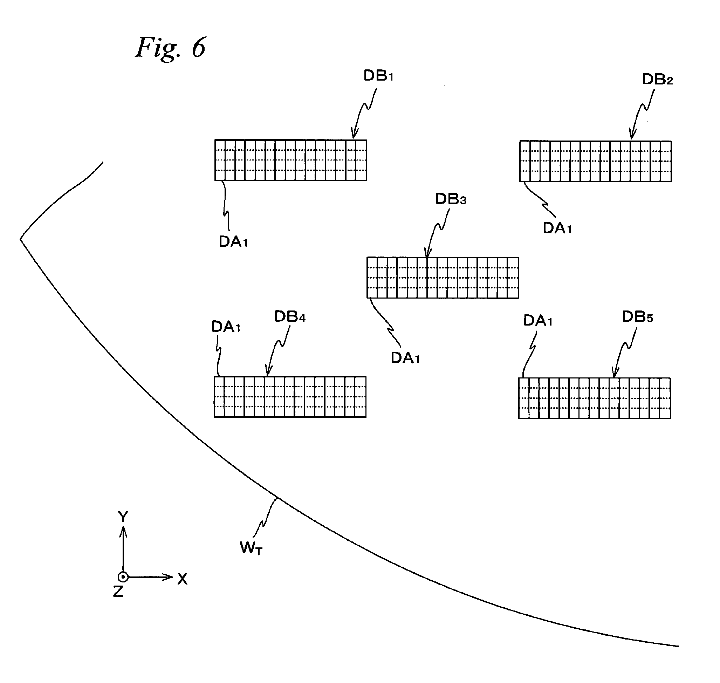

First of all, in step 402 in FIG. 4, reticle $R_T$ is loaded on reticle stage RST via a reticle loader (not shown), and also wafer $W_T$ (refer to FIG. 6) is loaded on wafer table 18 via a wafer loader (not shown).

In the next step, step 404, predetermined preparatory operations such as alignment of reticle $R_T$ with projection optical system PL are performed. To be specific, reticle stage RST and wafer stage WST (XY stage 20) are moved based on measurement values of leaser interferometers 14 and 26 respectively so that a pair of fiducial marks (not shown) of fiducial plate FP arranged on wafer table 18 and a pair of reticle alignment marks RM1 and RM2 are detected by the reticle alignment detection systems (not shown). Then, based on detection results of the reticle alignment detection systems, the position (including the rotation) of reticle stage RST within the XY plane is adjusted. With this operation, rectangular area IAR' of reticle $R_T$ is set within the above-described illumination area, and its entire surface is irradiated with illumination light IL. Further, in the present embodiment, the position where a projected image of measurement pattern $MP_n$ (a pattern image) is generated within the field (the exposure area in particular) via projection optical system PL becomes an evaluation point where the optical characteristics (e.g. a focus position) should be measured within the exposure area of projection optical system PL. Incidentally, the number of the evaluation point may be at least one, but in the present embodiment, five evaluation points in total, which are located in the center and in four corners of the exposure area described above, are set.

In this manner, when the predetermined preparatory operations end, the procedure moves to the next step, step 406, in which a target value of an exposure energy amount is set to the optimal value. The optimal value of the exposure energy amount has been obtained beforehand by experiment or simulation, or the like.

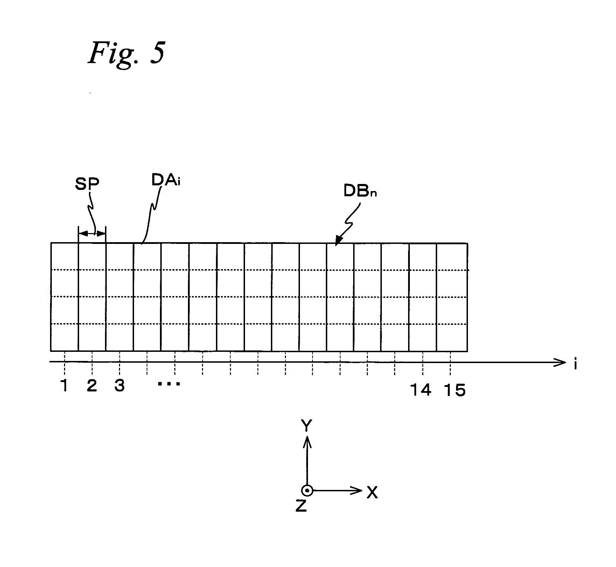

In the next step, step 408, a count value i of a first counter is initialized (i←1). In the present embodiment, the count value i is used not only for setting a target value $Z_i$ of the focus position of wafer $W_T$ but also for setting a divided area $DA_i$ subject to exposure in step 410 (to be described later, refer to FIG. 5). In the present embodiment, for example, assuming the known best focus position (such as the design value) related to projection optical system PL as the center, the focus position of wafer $W_T$ is changed per $\Delta Z$ from $Z_1$ to $Z_M$ (M=15 as an example, $Z_i=Z_1$ to $Z_{15}$).

Accordingly, in the present embodiment, while changing the position (the focus position) of wafer $W_T$ in the optical axis direction of projection optical system PL (the Z-axis direction), M times of exposure (M=15 in this example) to sequentially transfer measurement pattern $M_P$ (n=1 to 5) onto wafer $W_T$ are to be performed. In the present embodiment, a projection area of aperture pattern $AP_n$ by projection optical system PL is referred to as a measurement pattern area, and a projected image of measurement pattern $MP_n$ is generated within the measurement pattern area and aperture pattern $AP_n$ is transferred onto wafer $W_T$ by each exposure, thereby forming a divided area including the transferred image of measurement pattern $MP_n$. Therefore, the 1xM number of measurement patterns $MP_n$ are transferred to areas (hereafter, referred to as "evaluation-point-corresponding areas") $DB_1$ to $DB_5$ on wafer $W_T$ (refer to FIG. 6) that correspond to the respective evaluation points within the exposure area (which corresponds to the illumination area described above) of projection optical system PL.

Each evaluation-point-corresponding area $DB_n$ on wafer $W_T$ to which measurement pattern $MP_n$ is transferred by exposure (to be described later) will be described next for the sake of convenience, using FIG. 5, although the description is made out of sequence. As is shown in FIG. 5, in the present embodiment, measurement pattern $MP_n$ is transferred to each of the M number (1xM=M, e.g. 1x15=15) of virtual divided areas $DA_i$ (i=1 to M (e.g. M=15)) that are placed in the matrix shape having 1 row and M columns (e.g. 1 row and 15 columns), and evaluation-point-corresponding area $DB_n$ that is composed of the M number (e.g. 15) of divided areas $DA_i$ to which measurement pattern $MP_n$ is respectively transferred is formed on wafer $W_T$. Incidentally, as is shown in FIG. 5, virtual divided areas $DA_i$ are disposed so that the +X direction serves as the column direction (the direction in which "i" increases). Further, the suffixes "i" and "M" that are used in the following description are to have the same meaning as described above.

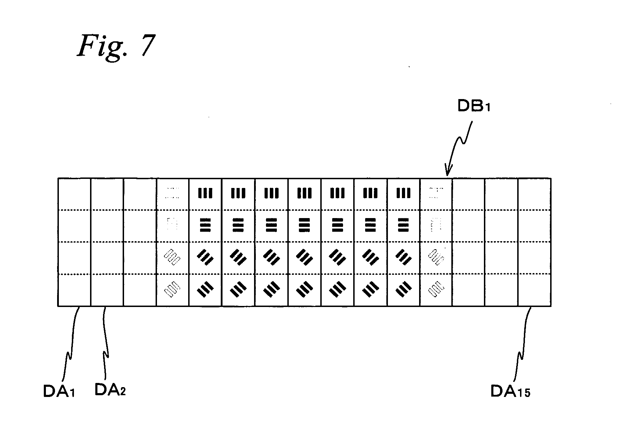

Referring back to FIG. 4, in the next step, step 410, wafer $W_T$ is moved to target position $Z_i$ ($Z_1$ in this case) in the Z-axis direction by driving wafer table 18 in the Z-axis direction (and the inclination direction) while monitoring the measurement values from focus sensor AFS, and also wafer $W_T$ is moved within the XY plane and virtual divided area $DA_i$ ($DA_1$ in this case (refer to FIG. 7)) within each evaluation-point-corresponding area $DB_n$ (n=1, 2 ····· 5) on wafer $W_T$ is exposed, thereby severally transferring an image of measurement pattern $MP_n$ to the virtual divided area $DA_i$ ($DA_1$ in this case). When performing this operation, exposure dose control is performed so that the exposure energy amount (the total exposure dose) at one point on wafer $W_T$ becomes the set target value.

With this operation, as is shown in FIG. 6, an image of aperture pattern $AP_n$ including measurement pattern $MP_n$ is severally transferred to divided area $DA_1$ of each evaluation-point-corresponding area $DB_n$ on wafer $W_T$.

Referring back to FIG. 4, when exposure in step 410 described above ends, the procedure proceeds to step 416, in which the judgment is made of whether exposure in a predetermined Z range ends or not, by judging whether or not the target value of focus position of wafer $W_T$ is greater than or equal to $Z_M$ (whether the counter value i is greater than or equal to M). In this case, only exposure at the first target value $Z_1$ ends, the procedure moves to step 418, and after the count value i is incremented by one (i←i+1), the procedure returns to step 410. In step 410, wafer $W_T$ is moved to target position $Z_2$ in the Z-axis direction by driving wafer table 18 in the Z-axis direction (and the inclination direction), and also wafer $W_T$ is moved within the XY plane and virtual divided area $DA_2$ within each evaluation-point-corresponding area $DB_n$ (n=1, 2 ····· 5) on wafer $W_T$ is exposed, thereby severally transferring aperture pattern $AP_n$ including measurement pattern $MP_n$ to divided area $DA_2$. When performing this operation, prior to starting exposure, XY stage 20 is moved in a predetermined direction within the XY plane (the -X direction in this case) by a predetermined step pitch SP (refer to FIG. 5). In this case, in the present embodiment, step pitch SP is set to around

6.75$\mu$m, which substantially coincides with the size in the X-axis direction of a projected image (corresponding to the measurement pattern area) of each aperture pattern $AP_n$ projected on wafer $W_T$. Incidentally, step pitch SP is not limited to around 6.75$\mu$m, but is desirably the size with which images of measurement patterns $MP_n$ that are respectively transferred to adjacent divided areas do not overlap with each other and which is less than or equal to the size in the X-axis direction of a projected image (corresponding to the measurement pattern area) of each aperture pattern $AP_n$ on wafer $W_T$. The reason will be described later.

In this case, since step pitch SP is less than or equal to the size in the X-axis direction of a projected image of aperture pattern $AP_n$ on wafer $W_T$, a frame line that is formed by a part of the image of aperture pattern $AP_n$ or a not-yet-exposed area does not exist in a boundary portion between divided area $DA_1$ and divided area $DA_2$ of each evaluation-point-corresponding area $DB_n$.

After that, until the judgment in step 416 is affirmed, that is, until the judgment is made that the target value of the focus position of wafer $W_T$ that is set at the point in time is $Z_M$, the loop processing (including the judgment) of steps 416→418→410 are repeated. With this operation, aperture pattern $AP_n$ including measurement pattern $MP_n$ is respectively transferred to divided areas $DA_i$ (i=3 to M) of each evaluation-point-corresponding area $DB_n$ on wafer $W_T$. Also in this case, the frame line or the not-yet-exposed area does not exist in the boundary portion between adjacent divided areas for the same reason as described above.

Meanwhile, when exposure to divided area $DA_M$ ($DA_{15}$ in this example) of each evaluation-point-corresponding area $DB_n$ ends and the judgment in step 416 described above is affirmed, the procedure moves to step 420. At the stage where the judgment in step 416 is affirmed, as is shown in FIG. 6, transferred images (latent images) of the M number (M=15 in this example) of measurement patterns $MP_n$, which were transferred under different exposure conditions (the different focus positions in this example), are formed. Incidentally, in actual, at the stage where the M number (15 in this example) of divided areas, in which transferred images (latent images) of measurement patterns $MP_n$ are formed, are formed on wafer $W_T$, each evaluation-point-corresponding area $DB_n$ is formed. In the above description, however, the explanation is made as if there were evaluation-point-corresponding areas $DB_n$ beforehand on wafer $W_T$, in order to facilitate the description.

Referring back to FIG. 4, in step 420, wafer $W_T$ is unloaded from wafer table 18 via a wafer unloader (not shown), and also wafer $W_T$ is carried to a coater/developer (not shown) that is inline connected to exposure apparatus 100 using a wafer carriage system (not shown).

After the carriage of wafer $W_T$ to the coater/developer described above, the procedure proceeds to step 422 to wait until the development of wafer $W_T$ ends.

During the waiting time in step 422, the development of wafer $W_T$ is performed by the coater/developer. By finishing the development, resist images of evaluation-point-corresponding areas $DB_n$ (n=1 to 5) as is shown in FIG. 6 are formed on wafer $W_T$ and the wafer $W_T$ on which the resist images are formed serves as a sample used to measure the optical characteristics of projection optical system PL. FIG. 7 shows an example of a resist image of evaluation-point-corresponding area $DB_1$ formed on wafer $W_T$.

In FIG. 7, evaluation-point-corresponding area $DB_1$ is configured of the M number (=15) of divided areas $DA_i$ (i=1 to 15), and resist images of partition frames are shown between adjacent divided areas as if they exist, but they are shown only to make individual divided areas clear. In actual, however, the resist images of the partition frames do not exist between the adjacent divided areas. Since there are no frames as is described above, the decrease in contrast of the pattern section due to interference by the frames can be prevented from occurring, when capturing images of evaluation-point-corresponding areas $DB_n$ by alignment detection system AS described above or the like. Therefore, in this embodiment, the size of step pitch SP described previously is set to less than or equal to the X-axis size of a projected image of each aperture pattern $AP_n$ on wafer $W_T$. Incidentally, the boundaries between areas (hereinafter, referred to as "measurement mark areas" as needed) in which images of L/S patterns are formed, which are indicated by dotted lines within each divided area in FIG. 7 do not exist in actual either.

When confirming that the development of wafer $W_T$ ends by a notice from a control system of the coater/developer (not shown) in the waiting state in step 422 described above, the procedure moves to step 424, and wafer $W_T$ is loaded again on wafer table 18 similarly to step 402 described above by transmitting instructions to a wafer loader (not shown), and then the procedure moves to a subroutine (hereinafter, also referred to as an "optical characteristics measurement routine") in step 426 in which the optical characteristics of the projection optical system are computed.

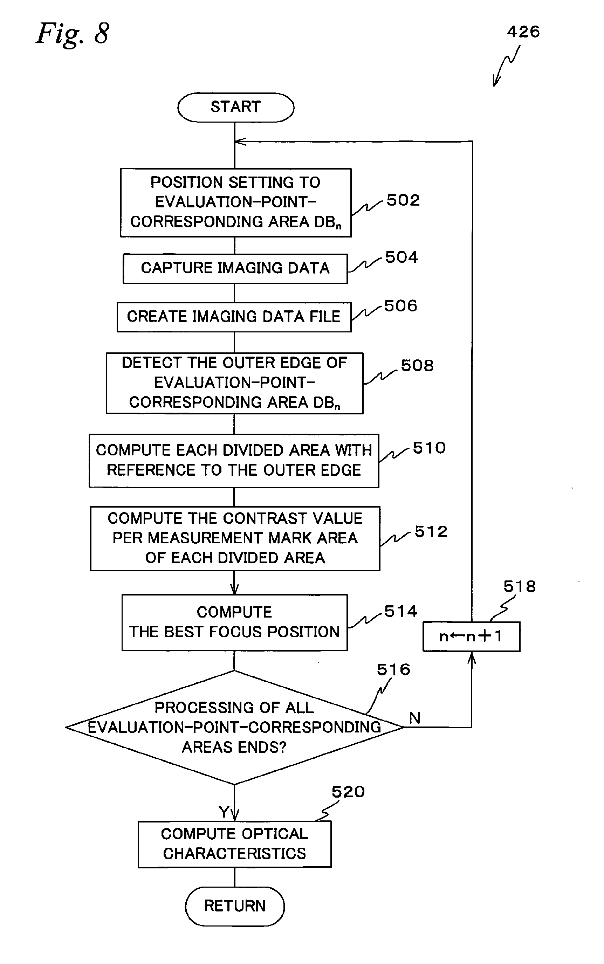

In the optical characteristics measurement routine, first of all, in step 502 in FIG. 8, by referring to the count value n of a second counter that indicates the number of the evaluation-point-corresponding area subject to detection, wafer $W_T$ is moved to a position at which a resist image of evaluation-point-corresponding area $DB_n$ on wafer $W_T$ can be detected by alignment detection system AS. This movement, that is, the position setting is performed by controlling XY stage 20 via drive system 22 while monitoring measurement values of laser interferometer 26. In this case, the count value n is assumed to be initialized to one (n=1). Accordingly, herein, the position of wafer $W_T$ is set at a position at which a resist image of evaluation-point-corresponding area $DB_1$ on wafer $W_T$ shown in FIG. 7 can be detected by alignment detection system AS. In the following description of the optical characteristics measurement routine, the resist image of evaluation-point-corresponding area $DB_n$ will be shortly referred to as "evaluation-point-corresponding area $DB_n$" as needed.

In the next step, step 504, the resist image of evaluation-point-corresponding area $DB_n$ ($DB_1$ in this case) on wafer $W_T$ is imaged using alignment detection system AS, and the imaging data is captured. Alignment detection system AS divides the resist image per pixel unit of an imaging device (such as CCD) that alignment detection system AS has, and supplies the grayscale of the resist image corresponding to each pixel to main controller 28, for example, as 8-bit digital data (pixel data) . That is, the imaging data described above is composed of a plurality of pixel data. In this case, the value of pixel data is to increase as the resist image is deeper in color (i.e. is closer to black). Incidentally, in the present embodiment, since evaluation-point-corresponding area $DB_n$ has a size of 101.25$\mu$m (in the X-axis direction) x 27$\mu$m (in the Y-axis direction) and its entire area is set within the detection area of alignment detection system AS, the M number of divided areas $DA_i$ can be imaged simultaneously (in block) per evaluation-point-corresponding area.

In the next step, step 506, the imaging data of the resist images formed in evaluation-point-corresponding area $DB_n$ ($DB_1$ in this case) from alignment detection system AS are properly arranged and an imaging data file is created.

In the next step, step 508, the outer edge of evaluation-point-corresponding area $DB_n$ ($DB_1$ in this case) is detected by performing the image processing of the imaging data. The detection of the outer edge can be performed as will be described below, as an example.

That is, by assuming a direct line portion constituting an outer frame composed of a contour of evaluation-point-corresponding area $DB_n$ as a detection subject and scanning a window area having a predetermined size in a direction substantially orthogonal to the direct line portion as the detection subject based on the imaging data obtained by the imaging, the position of the direct line portion as the detection subject is detected based on pixel data within the window area during the scanning. In this case, the pixel data of the outer frame portion is quite different in pixel value from that of other portions, and therefore, the position of the direct line portion (a part of the outer frame) as the detection subject can be detected without fail, for example, based on the change in pixel data within the window area according to the change of the position of the window area per one pixel in the scanning direction. In this case, the scanning direction is desirably a direction from the inside to the outside of the outer frame. This is because when the peak of the pixel values corresponding to the pixel data within the window area is obtained for the first time, the peak position coincides with the position of the outer frame without fail, and thus the outer frame detection can surely be performed.

The detection of the direct line portion as is described above is performed with respect to each of four sides constituting the outer frame composed of the contour of evaluation-point-corresponding area $DB_n$. The detection of the outer frame is disclosed in detail in, for example, Kokai (Japanese Unexamined Patent Application Publication) No. 2004-146702.

In the next step, step 510, by equally dividing the outer edge of evaluation-point-corresponding area $DB_n$ detected above, that is, the internal section of the rectangular frame line into the M number (e.g. into 15) in the X-axis direction, divided areas $DA_1$ to $DA_M$ ($DA_{15}$) are obtained. That is, (positional information of) each divided area is obtained with reference to the outer edge.

In the next step, step 512, the contrast value per measurement mark area regarding each divide area $DA_i$ (i=1 to M) (or the contrast value per divided area $DA_i$) is computed.

In this case, the contrast value per measurement mark area means the statistic expressed in the following equation (1), that is, the variance of the luminance value of each pixel regarding the measurement mark area.

[Equation 1]

$$C_1 = \frac{\sum_{k=1}^{N}(x_k - x^*)^2}{N-1} \quad \cdots (1)$$

Herein, $x_k$ denotes the luminance value of the $k^{th}$ pixel. inside the measurement mark area, $x^*$ denotes a predetermined reference value. As the predetermined reference value, in this embodiment, the average value of luminance values of a plurality of pixels (or a luminance value of a single pixel) in an area where there no image (no measurement pattern image) of measurement pattern $MP_n$ (specifically, L/S patterns $LS_{vn}$, $LS_{Hn}$, $LS_{Rn}$ and $LS_{Ln}$) inside at least one divided area (or measurement mark area) on wafer $W_T$ is used. Further, N denotes the total number of pixels inside the measurement mark area. Incidentally, a predetermined reference value $X^*$ may also be the average value of luminance values of all pixels inside the relevant measurement mark area, similarly to the case of usual variance.

Incidentally, as the contrast value, the standard deviation of the luminance value of each pixel regarding the measurement mark area shown in the following equation (2) may also be used.

[Equation 2]

$$C_2 = \sqrt{\frac{\sum\limits_{k=1}^{N}(x_k - x^*)^2}{N-1}} \quad \cdots (2)$$

Or, as the contrast value, another statistic including the deviation of the luminance value of each pixel with respect to the predetermined reference value described above may also be used for each measurement mark area (or each divided area).

Incidentally, in step 512, also in the case of computing the contrast value for each divided area, the variance, the standard deviation or another statistic of the luminance value of each pixel similar to the above-described case is used.

That is, in step 512, imaging data of each divided area $DA_i$ is extracted from the imaging data file described above, and the contrast value per measurement mark area in each divided area $DA_i$ (i=1 to M) (or the contrast value per divided area) is computed using the above equation (1) or (2).

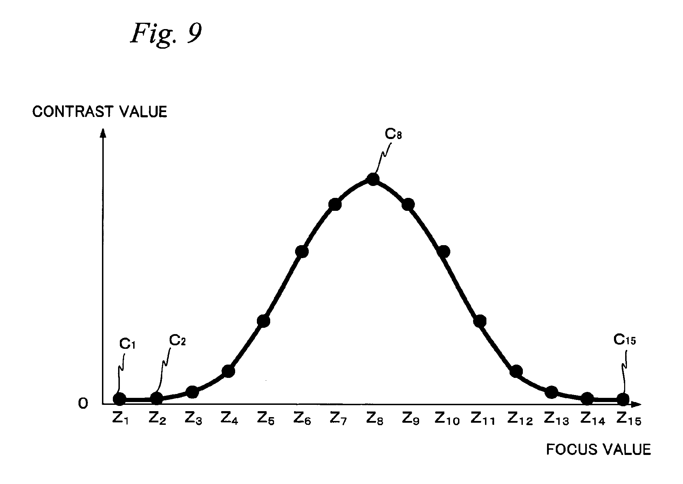

In the next step, step 514, based on the contrast value computed in step 512 described above, the best focus position concerning evaluation-point-corresponding area $DB_n$ is computed in the manner described below and the best focus position is stored in a storage device (not shown). That is, regarding evaluation-point-corresponding area $DB_n$, the average value of the contrast values in the case of using L/S patterns $LS_{vn}$, $LS_{Hn}$, $LS_{Rn}$ and $LS_{Ln}$ respectively is computed as the contrast value of each divided area $DA_i$ (i= 1 to M) based on the contrast value per measurement mark area computed in step 512 described above. Next, regarding evaluation-point-corresponding area $DB_n$, the computed contrast value of each divided area $DA_i$ (i= 1 to M) (or the contrast value per divided area computed in step 512) is plotted on a graph having a horizontal axis that shows a focus value Z, as is shown in FIG. 9, and $Z_i$ ($Z_8$ in FIG. 9) corresponding to a plot point $C_i$ ($C_8$ in FIG. 9) where the contrast value becomes maximum out of the M number (15 in this case) of plot points is to be a best focus position $Z_{best}$. Or, regarding evaluation-point-corresponding area $DB_n$, for example, an approximate curve, which is obtained by the least squares approximation of the plot points, is drawn as is shown in FIG. 9, and the average value of values at two intersecting points of the approximate curve with a predetermined slice level may be assumed to be the best focus position $Z_{best}$.

In the next step, step 516, the judgment is made of whether the processing of all evaluation-point-corresponding areas $DB_1$ to $DB_5$ has ended or not, referring to the count value n described above. In this case, since only the processing of evaluation-point-corresponding area $DB_1$ has ended, the judgment in step 516 is denied, and after the procedure proceeds to step 518, in which the count value n is incremented by one (n←n+1), the procedure returns to step 502 and the position of wafer $W_T$ is set at a position where evaluation-point-corresponding area $DB_2$ can be detected by alignment detection system AS.

Then, the processing (including the judgment) of steps 504 to 514 described above is performed again, and the best focus position is obtained for evaluation-point-corresponding area $DB_2$ in the manner similar to the case of evaluation-point-corresponding area $DB_1$ described above.

Then, when the computation of the best focus position for evaluation-point-corresponding area $DB_2$ ends, whether the processing of all evaluation-point-corresponding areas $DB_1$ to $DB_5$ has ended or not is judged again in step 516, but the judgment is denied in this case. After that, until the judgment in step 516 is affirmed, the processing (including the judgment) in steps 502 to 518 described above is repeated. With this operation, the best focus position is respectively obtained for other evaluation-point-corresponding areas $DB_3$ to $DB_5$ in the manner similar to the case of evaluation-point-corresponding area $DB_1$ described above.

In this manner, when performing the computation of the best focus positions for all evaluation-point-corresponding areas $DB_1$ to $DB_5$ on wafer $W_T$, that is, the computation of the best focus positions at the respective evaluation points described above that are projection positions of five measurement patterns $MP_1$ to $MP_5$ within the exposure area of projection optical system PL, the judgment in step 516 is affirmed. The optical characteristics measurement routine may be finished at this stage, but in this embodiment, the procedure moves to step 520, and other optical characteristics are computed based on the best focus position data obtained as is described above.

For example, in step 520, based on data of the best focus positions concerning evaluation-point-corresponding areas $DB_1$ to $DB_5$, the curvature of field of projection optical system PL is computed as an example. Further, other characteristics such as the depth of focus at each evaluation point within the exposure area described above may also be obtained.

Herein, in the present embodiment, for simplification of the description, a single best focus position is to be obtained based on the average value of the contrast values of images of four types of L/S patterns in each evaluation-point-corresponding area (the position corresponding to each evaluation point), but the present invention is not limited thereto, and the best focus position may also be obtained with respect to each periodic direction of an L/S pattern based on the contrast value per image of the L/S pattern. Or, astigmatism at each evaluation point may also be obtained from the best focus positions that are respectively obtained for a pair of L/S patterns (e.g. $LS_{Rn}$ and $LS_{Ln}$) which periodic directions are orthogonal to each other. Moreover, for each evaluation point within the exposure area of projection optical system PL, based on the astigmatism computed as is described above, regularity within the astigmatism surface can be obtained by performing the approximation processing, for example, in the least-squares method, and also the total focus difference can be obtained from the regularity within the astigmatism surface and the curvature of field.

Then, optical characteristics data of projection optical system PL obtained as described above is stored in a storage device (not shown) and also displayed on the screen of a display device (not shown). With this operation, the processing of step 520 in FIG. 8, that is, the processing of step 426 in FIG. 4 is finished, and a series of measurement processing of the optical characteristics is finished.

Next, the exposure operation by exposure apparatus 100 in the present embodiment in the case of device manufacturing will be described.

As a premise, information on the best focus position decided in the manner described above, or in addition to such information, information on the curvature of field has been input to main controller 28 via an input/output device (not shown).

For example, in the case where the information on the curvature of field is input, prior to exposure, main controller 28 instructs the image-forming characteristics correction controller (not shown) based on the optical characteristics data so as to correct the image-forming characteristics of projection optical system PL as much as possible in order to correct the curvature of field by changing, for example, the position (including the distance between other optical elements) or the inclination of at least one optical element (which is a lens element in this embodiment, but depending on the configuration of an optical system, for example, which may also be a catoptric element such as a concave mirror, or an aberration correcting plate that corrects aberration (such as distortion and spherical aberration), in particular, a non-rotational symmetric component thereof in projection optical system PL. In this case, as the correction method of image-forming characteristics of projection optical system PL, for example, a method of slightly shifting the center wavelength of illumination light IL, or a method of changing the refractive index in a part of projection optical system PL may be employed by itself or in combination with the movement of an optical element.

Then, main controller 28 loads reticle R on which a predetermined circuit pattern (device pattern) is formed that is subject to transfer onto reticle stage RST using the reticle loader (not shown), and similarly, loads wafer W onto wafer table 18 using the wafer loader (not shown).

Next, main controller 28 performs preparatory operations such as reticle alignment and baseline measurement in predetermined procedures using a reticle alignment detection system (not shown), fiducial plate FP on wafer table 18, alignment detection system AS and the like, and following to such operations, wafer alignment based on, for example, the EGA (Enhanced Global Alignment) method or the like is performed.

When the wafer alignment described above ends, main controller 28 controls the respective sections of exposure apparatus 100 and scanning exposure of shot areas on wafer W and an inter-shot stepping operation are repeatedly performed, and the pattern of reticle R is sequentially transferred onto all the shot areas subject to exposure on wafer W.

During the scanning exposure described above, main controller 28 performs focus-leveling control of wafer W by driving wafer table 18 in the Z-axis direction and in the inclination direction via drive system 22 based on positional information of wafer W in the Z-axis direction detected by focus sensor AFS so that the surface of wafer W (shot areas) is set within a range of the depth of focus within the exposure area of projection optical system PL after the above-described correction of optical characteristics. In the present embodiment, prior to the exposure operation of wafer W, the image plane of projection optical system PL has been computed based on the best focus position at each evaluation point described above, and based on the computation results, optical calibration of focus sensor AFS (such as adjustment of the inclination angle of a parallel plane plate placed within photodetection system 50b) has been performed. The present invention is not limited thereto, but, for example, the focus operation (and the leveling operation) may also be performed taking into consideration the offset in accordance with the deviation between the image plane computed in advance and the detection criterion of focus sensor AFS.

As is described above, according to the optical characteristics measurement method related to the present embodiment, for a plurality of divided areas $DA_i$ of each evaluation-point-corresponding area $DB_n$ on wafer $W_T$ to which measurement pattern $MP_n$ is transferred and exposed, a predetermined statistic related to the luminance value of each pixel included in the imaging data that is obtained by the imaging of each evaluation-point-corresponding area $DB_n$, for example, the variance or the standard deviation is computed as the contrast, and based on the computation results of the computed contrast of each area, the best focus position at each evaluation point of projection optical system, and the optical characteristics such as the curvature of field and the astigmatism that are obtained from the best focus position at each evaluation point are obtained. In this manner, because the statistic related to the luminance value of each pixel is computed as the contrast for divided area $DA_i$, even a microscope having a resolution lower than the SEM and the like, for example, the measurement device such as alignment detection system AS of exposure apparatus 100 can perform the measurement. Accordingly, strict focusing as in the case of using the SEM becomes unnecessary, which can shorten the measurement time. For example, also in the case of not imaging each evaluation-point-corresponding area $DB_n$ simultaneously as is described above but imaging each divided area $DA_i$ separately, the measurement time per divided area can be shortened. Further, the measurement can be performed regardless of the types of pattern images (such as a line-and-space (an isolated line, a dense line), a contact hole, the size and the disposed direction), and regardless of illumination conditions when generating a projected image (a pattern image) of measurement pattern $MP_n$.

Further, in this embodiment, because the contrast described above is detected, other patterns (such as a reference pattern for comparison, or a mark pattern for position setting) than measurement pattern $MP_n$ do not have to be placed within pattern area PA of reticle $R_T$. Further, the measurement pattern can be reduced in size, compared with the conventional method of measuring the size (such as the CD/Focus method or the SMP focus measurement method). Therefore, the number of evaluation points can be increased, and also the distance between the evaluation points can be shortened. As a consequence, the measurement accuracy of the optical characteristics and the repeatability of the measurement results can be improved.

Further, according to exposure apparatus 100, the pattern formed on reticle R is transferred onto wafer W via projection optical system PL, after performing the operation related to adjustment of the image-forming state of the pattern image to be projected on wafer W via projection optical system PL, for example, adjustment of image-forming characteristics by movement of the optical element in projection optical system PL, or the calibration of focus sensor AFS so that the optimal transfer can be performed taking into account the optical characteristics of projection optical system PL that are accurately measured in the optical characteristics measurement method described above.

Therefore, according to the exposure method related to the present embodiment, the optical characteristics of projection optical system PL are measured with high precision using the above-described optical characteristics measurement method and the high-precision pattern image is generated within the exposure area of projection optical system PL taking the measurement results of the optical characteristics into consideration, and accordingly high-precision exposure (pattern transfer) is realized.

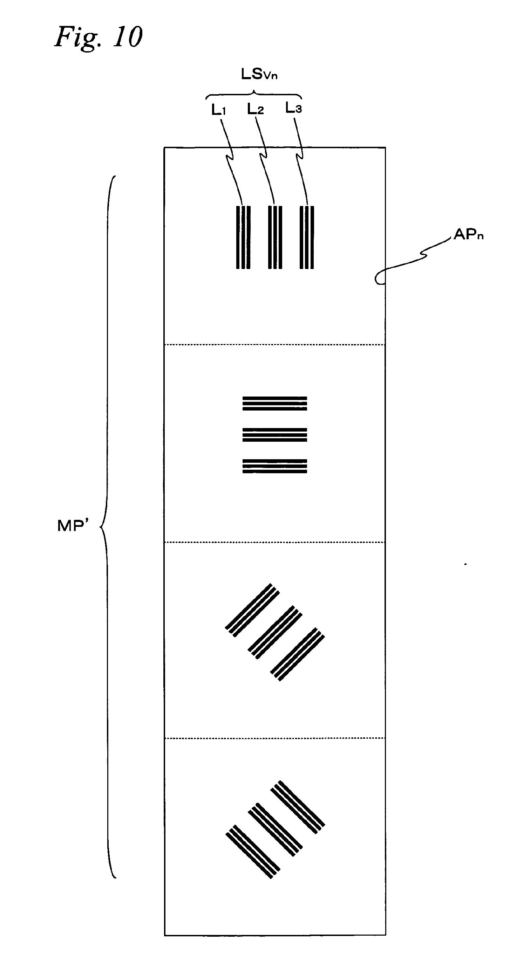

Incidentally, in the embodiment above, as each line-and-space pattern constituting measurement pattern $MP_n$, an L/S pattern having a $3.2\mu m$ pitch (linewidth: $1.6\mu m$) on reticle $R_T$ is used, but the present invention is not limited thereto, and an L/S pattern having a narrower line width (or pitch) may also be used as the measurement pattern. Also in this case, the pitch or the linewidth (the reduced value on the wafer) of the L/S pattern is nearly equal to or greater than the resolution limit of the measurement device (the optical system) such as alignment detection system AS. Further, as is shown in FIG. 10, for example, a pattern MP' that is composed of three lines and two spaces, which are obtained by dividing a line having a $1.6\mu m$ linewidth (whose reduced value on the wafer is a $0.4\mu m$ linewidth) that constitutes each L/S pattern of measurement pattern $MP_n$ in the above embodiment into five, may also be employed as the measurement pattern. In the case of pattern MP', the width of each line (such as $L_1$, $L_2$ and $L_3$) and each space becomes 80nm on the wafer. When such a pattern is used, "the change in contrast" with respect to the focus change increases and the best focus position can be detected with high sensitivity, which is more preferable. In this case, the linewidth (or pitch) (the reduced value on the wafer) of each of a plurality of lines that constitute each line pattern of the L/S pattern is set less than the resolution limit of the measurement device (the optical system) such as alignment detection system AS. Further, the linewidth (or pitch) of each of the plurality of lines (the reduced value on the wafer) may be equal to around the resolution limit (e.g. 80nm in this example) of exposure apparatus 100 (projection optical system PL) or may be greater than the resolution limit, but is preferably less than or equal to around four times (320nm in this example) the resolution limit. Herein, in the case of using an L/S pattern in which each line pattern is composed of a plurality of lines each having a linewidth (or pitch) that is around four times the resolution limit of exposure apparatus 100, the resolution of the measurement device such as alignment detection system AS does not have to be high (does not have to have the high resolution), although it cannot be said that the focus measurement with high sensitivity is performed. That is, a measurement device that has an optical system having a low resolution, for example, an optical system whose resolution limit is greater than a quarter of the resolution limit of exposure apparatus 100 (320nm in this example) can be used, and the cost for the device can be reduced. In this case, the resolution limit of the measurement device (the detection resolution of the optical system) is, for example, 350nm, and a measurement pattern image having a linewidth of 400nm (a pitch of 800nm) described above can be resolved (detected). Incidentally, in order to perform the focus measurement with high sensitivity, the linewidth (or pitch) (the reduced value on the wafer) of each of the plurality of lines is preferably, for example, less than or equal to around three times (240nm in this example) the resolution limit of exposure apparatus 100. Further, in the case of using the L/S pattern shown in FIG. 10, the linewidth (or pitch) of the L/S pattern may also be wider than that of the embodiment described above (a $0.4\mu m$ linewidth and a $0.8\mu m$ pitch on the wafer). Moreover, measurement pattern MP' in FIG. 10 is to have L/S patterns, but may have, for example, one line pattern composed of a plurality of lines each having the linewidth (or pitch) described above, instead of the L/S patterns.

Further, in the embodiment described above, the case has been described where four types of L/S patterns (multi-bar patterns) that are placed within aperture pattern $AP_n$ are used as measurement pattern $MP_n$ on reticle $R_T$. However, the present invention is not limited thereto, and the measurement pattern may include only one pattern in number or type, or an isolated line or a contact hole may also be used instead of or in combination with the L/S patterns. Further, in the case where the periodic pattern is used as measurement pattern $MP_n$, the periodic pattern is not limited to the L/S pattern, but for example, a pattern having dot marks that are periodically disposed may also be used. This is because the contrast described above is detected, which is different from the conventional method in which the linewidth of an image or the like is measured.

Further, in the embodiment described above, the entire area of each evaluation-point-corresponding area is to be simultaneously imaged, but for example, a plurality of sections of one evaluation-point-corresponding area may also be imaged separately. In this case, for example, the entire area of the evaluation-point-corresponding area is set within the detection area of alignment detection system AS and a plurality of sections of the evaluation-point-corresponding area may be imaged at different timing, or the plurality of sections of the evaluation-point-corresponding area are sequentially set within the detection area of alignment detection system AS and the imaging of the set section may be performed. Moreover, a plurality of divided areas that constitute one evaluation-point-corresponding area $DB_n$ are to be formed adjacent to each other, but for example, a portion of the evaluation-point-corresponding area (at least one divided area) may be formed spaced apart from the other portions at a distance longer than or equal to a distance corresponding to the size of the detection area of alignment detection system AS. Further, in the embodiment described above, a plurality of divided areas are to be disposed in a row in each evaluation-point-corresponding area, but the positions of a plurality of divided areas in a direction (the Y-axis direction) orthogonal to the disposed direction (the X-axis direction) may be partially different, or for example, in the cases such as when the length of the evaluation-point-corresponding area in the disposed direction (the X-axis direction) is longer than the size of the detection area of alignment detection system AS, the divided areas may also be placed in a plurality of rows (i. e. two dimensionally) in each evaluation-point-corresponding area. That is, the placement (layout) of a plurality of divided areas may also be decided in accordance with the size of the detection area of alignment detection system AS so that the entire area of each evaluation-point-corresponding area can be simultaneously imaged. In this case, it is desirable to decide the step pitch in the Y-axis direction so that the frame line or the not-yet exposed portion referred to above does not exist also in the boundary portions of adjacent divided areas in the direction (the Y-axis direction) orthogonal to the disposed direction. Incidentally, measurement pattern $MP_n$ is to be transferred onto wafer $W_T$ by static exposure in the embodiment described above, but scanning exposure may also be employed instead of static exposure, and in the case of the scanning exposure, dynamic optical characteristics can be obtained. Further, exposure apparatus 100 of the present embodiment may be a liquid immersion type exposure apparatus, and in this case, by transferring an image of measurement pattern $MP_n$ onto a wafer via the projection optical system and liquid, optical characteristics of the projection optical system including the liquid can be measured.

Incidentally, in the embodiment described above, the case has been described where the variance or the standard deviation of the luminance value of each pixel per measurement mark area (or of each divided area $DA_i$), or another statistic including the deviation of the luminance value of each pixel with respect to a predetermined reference value concerning each measurement mark area (or each divided area) is used as the contrast value per measurement mark area (or of each divided area $DA_i$), but the present invention is not limited thereto. For example, information on the luminance value of each pixel concerning each measurement mark area (or each divided area) that does not include the above-described deviation, for example, a kind of statistic or the like related to the luminance value of each pixel such as the total value or the average value of the luminance values of the respective pixels within an area having a predetermined area size (a predetermined number of pixels) including the measurement pattern image out of the measurement mark area (or the divided area) may also be employed as the contrast information. The point is that any statistic related to the luminance value of each pixel may be used in the case where the area size (such as the number of pixels) of the imaging area that is used for computation of the contrast information is made to be constant for each measurement mark area (or each divided area). Further, for example, in the case where the area size of the imaging area is set so as to contain the measurement pattern image and also be smaller than or equal to around the area size of measurement mark area (or the divided area), step pitch SP of wafer $W_T$ when transferring the measurement patterns may be more than the size in the X-axis direction of a projected image (corresponding to the measurement pattern area described above) of each aperture pattern $AP_n$ on wafer $W_T$.

Incidentally, in the embodiment described above, for example, the imaging subject may be a latent image that is formed on the resist when performing exposure, or may also be other images such as an image (an etching image) that is obtained by developing a wafer on which the latent image is formed and further performing the etching processing of the wafer. Further, the photosensitive layer on which an image is formed on an object such as a wafer is not limited to the photoresist, but may be any layer on which an image (a latent image and a visible image) is formed by irradiation of light (energy), and for example, an optical recording layer or a magnetooptical recording layer may also be employed.

<<Second Embodiment>>

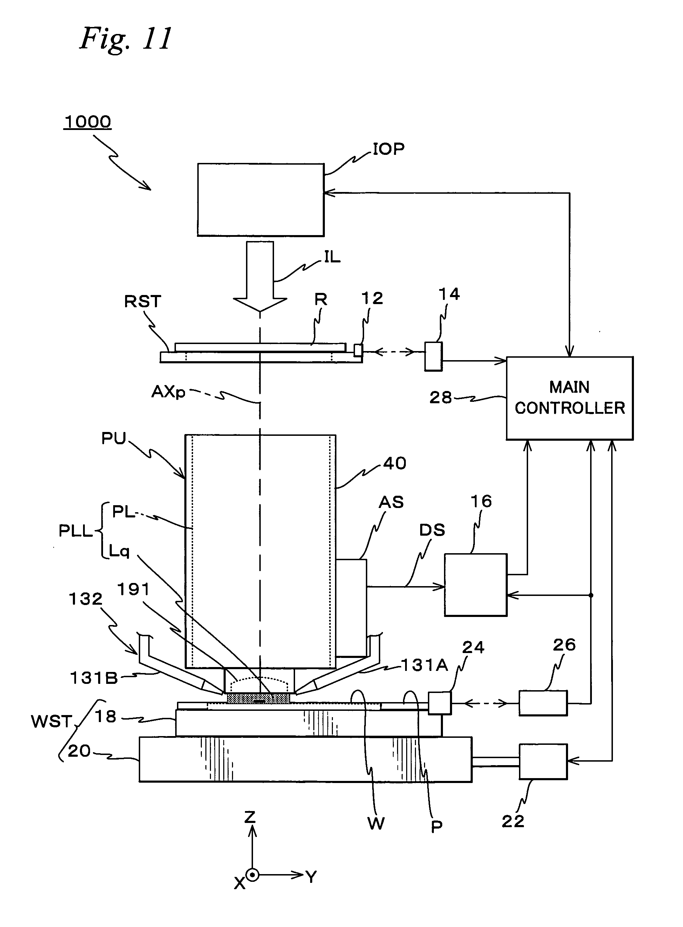

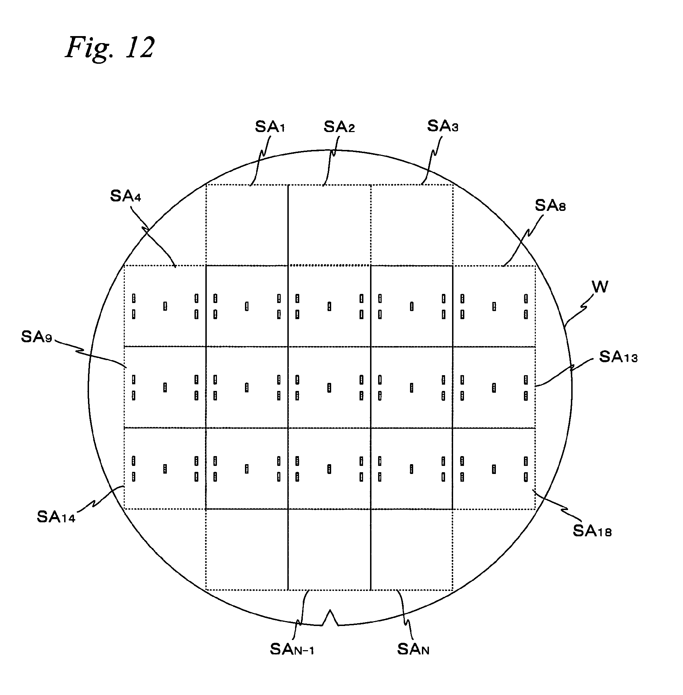

Next, a second embodiment of the present invention will be described referring to FIGS. 11 and 12. Herein, for the same or equivalent constituents as/to those of the first embodiment, the same reference codes will be used and the description for such constituents will be simplified or omitted.

FIG. 11 shows the schematic configuration of an exposure apparatus 1000 that is suitable to carry out an optical characteristics measurement method and an exposure method related to the second embodiment. Exposure apparatus 1000 is a reduced projection exposure apparatus by a step-and-scan method (a so-called scanning stepper (which is also called a scanner)).

Exposure apparatus 1000 is different from exposure apparatus 100 of the first embodiment described above in the following points such as: that a liquid supply nozzle 131A and a liquid recovery nozzle 131B that constitute a liquid immersion device 132 are arranged in the vicinity of a lens (hereinafter, also referred to as a "tip lens") 191 that is an optical element on the most image plane side (wafer W side) constituting projection optical system PL of projection unit PU; that the configuration of wafer table 18 is partially different due to the nozzles; and that liquid immersion exposure is performed, but the configuration of other sections and the like are similar to those of exposure apparatus 100. In the following description, the different points will be mainly described.

Liquid supply nozzle 131A is connected to a liquid supply device (not shown) via a supply pipe (not shown), and liquid recovery nozzle 131B is connected to a liquid recovery device (not shown) via a recovery pipe (not shown). In the present embodiment, as liquid Lq for liquid immersion (refer to FIG. 11), pure water (whose refractive index n is around 1.44) that transmits the ArF excimer laser light (light with a wavelength of 193 nm) is to be used. Pure water can be obtained in large quantities at a semiconductor manufacturing plant or the like without difficulty, and it also has an advantage of having no adverse effect on the resist on the wafer, to the optical lenses or the like.

Liquid immersion device 132 including liquid supply nozzle 131A and liquid recovery nozzle 131B is controlled by main controller 28. Main controller 28 supplies liquid Lq to the space between tip lens 191 and wafer W via liquid supply nozzle 131A, and also recovers liquid Lq from the space between tip lens 191 and wafer W via liquid recovery nozzle 131B. Accordingly, a constant amount of liquid Lq (refer to FIG. 11) is held in the space between tip lens 191 and wafer W.

Incidentally, the configuration of liquid immersion device 132 is not limited to the above-described configuration, but the configuration having multiple nozzles may also be employed as is disclosed in, for example, the Pamphlet of International Publication No. WO 99/49504. Further, liquid immersion device 132 may include, instead of liquid supply nozzle 131A and liquid recovery nozzle 131B, a member that has a supply opening used to supply liquid Lq to an optical path space through which illumination light IL passes, a lower surface to which the surface of wafer W is placed opposing when exposure is performed, and a recovery opening arranged on the lower surface, and that forms a liquid immersion space by filling the optical path space with liquid Lq. The point is that any configuration may be employed as long as liquid can be supplied to the space between tip lens 191 and wafer W. Further, not only the space between tip lens 191 and wafer W, but also, for example, the space between the tip lens of projection optical system PL and an adjacent optical element may also be filled with liquid Lq. These configurations are disclosed in, for example, the pamphlet of International Publication No. WO 2004/086468 (the corresponding U.S. Patent Application Publication No. 2005/0280791), Kokai (Japanese Unexamined Patent Application Publication) No. 2004-289126 (the corresponding U.S. Patent No. 6,952,253), European Patent Application Publication No. 1 420 298, the pamphlet of International Publication No. WO 2004/055803, the pamphlet of International Publication No. WO 2004/057590, the pamphlet of International Publication No. WO 2005/029559 and the like.

A wafer holder (FIG. 11 shows only a plate P constituting a part of the wafer holder) that holds wafer W by vacuum suction or the like is arranged on wafer table 18. The wafer holder is equipped with, for example, a main section (not shown) and plate P which is fixed on the upper surface of the main section and on which a circular opening that has a diameter larger than that of wafer W by around 0.1 to 2mm is formed in the center. In an area of the main section inside the larger circular opening of plate P, a plurality of pins are placed, and wafer W is supported by the plurality of pins and, is held by vacuum suction in a state where the surface of wafer W is substantially flush with the surface of plate P. A fiducial mark plate (not shown) that is similar to the one described above is arranged on a part of plate P. The entire surface of plate P is coated with a liquid-repellent material (a water-repellent material) such as a fluorine series resin material, an acrylic series resin material or the like, and a liquid-repellent film is formed. Further, on the surface of wafer W, a resist having liquid repellency to liquid Lq for liquid immersion is coated in this case, and a resist film is formed with the coated resist.

Next, a measurement method of optical characteristics of an optical system (hereinafter, referred to as an "optical system PLL" as needed, refer to FIG. 11) that includes projection optical system PL and liquid Lq in exposure apparatus 1000 will be described.

The measurement of optical characteristics of optical system PLL is performed basically according to the procedures similar to those in the first embodiment described above. The second embodiment, however, is different from the first embodiment in the following points: step pitch SP needed when moving wafer $W_T$ to perform scanning exposure of the second and subsequent divid-

ed areas $DA_i$ in step 410 of FIG. 4 is not around 6.75μm but is a stepping distance needed when performing exposure by a step-and-scan method and respectively forming device patterns in a plurality of shot areas on wafer W, that is, the size of the shot area in the X-axis direction, for example, 25mm; and exposure is performed by a liquid-immersion exposure method. Accordingly, 15 shot areas (resist images) like shot areas $SA_4$ to $SA_{18}$ shown in FIG. 12 each having measurement patterns $MP_1$ to $MP_5$ formed therein are formed on wafer $W_T$. Further, in this case, instead of the processing in steps 502 to 516 described above, capturing of imaging data of the areas where images of measurement patterns $MP_1$ to $MP_n$ are formed, creation of imaging data file, computation of contrast value per measurement mark area of each of the areas, and computation of the best focus position per evaluation point based on the computation of the contrast value are performed for each of shot areas $SA_4$ to $SA_{18}$.

The detailed description of other processing will be omitted herein because the processing is similar to that of the first embodiment.

Further, an operation for exposure on actual device manufacturing is similar to that of the first embodiment except that liquid immersion exposure is performed in the second embodiment.

As is described above, according to the optical characteristics measurement method related to the second embodiment, a plurality of divided areas on wafer $W_T$ are sequentially exposed by sequentially moving wafer $W_T$ by the stepping distance (i. e. the size of the shot area in the X-axis direction, e.g. 25mm) in inter-shot stepping when exposing wafer $W_T$ and generating an image of measurement pattern $MP_n$ within the exposure area of optical system PLL while changing one exposure condition, that is, while changing the position of wafer $W_T$ in the optical axis AXp direction. In this case, because the stepping distance described above is employed, the temperature variation of liquid Lq caused by exposure of the previous shot hardly affects exposure of the next shot, which is different from the case of employing a step pitch that is comparable to the step pitch in the first embodiment described above. Therefore, the temperature stability of liquid Lq can be favorably maintained when performing exposure of each shot. Thus, the image of measurement pattern $MP_n$ can be formed with high accuracy in a plurality of divided areas on wafer $W_T$, and the forming state of the image of measurement pattern $MP_n$ is detected and the optical characteristics of the optical system can accurately be obtained based on the detection result.

Further, according to the exposure method in exposure apparatus 1000, a wafer is exposed with an image of a device pattern that is formed via optical system PPL according to the optical characteristics measurement method described above, that is, projection optical system PL and liquid Lq. Accordingly, high-precision generation of the pattern image on the wafer by liquid immersion exposure using projection optical system PL is realized.

Incidentally, in the second embodiment described above, the case has been described where the exposure condition that is changed when transferring a measurement pattern is the position of wafer $W_T$ in the optical axis direction of optical system PLL (the focus position), but the present invention is not limited thereto. Besides the focus position, the exposure condition may include at least one of setting conditions of all the constituents related to exposure or the like, such as an exposure dose, an illumination condition (including a type of mask) when generating a pattern image, and the image-forming characteristics of optical system PLL.

Further, the step pitch is to be set substantially equivalent to the stepping distance on transfer of a device pattern in the second embodiment described above, but the step pitch is not limited thereto and may be decided in accordance with, for example, an exposure dose, a type (material) of a wafer and/or a resist or the like so that the temperature variation of liquid Lq caused by exposure falls within a predetermined permissible range. Further, an image of measurement pattern $MP_n$ is to be transferred in each divided area by scanning exposure in the second embodiment described above, but static exposure may be employed instead of scanning exposure, and also in this case, the step pitch is set in the similar manner.

Incidentally, an image formed in each divided area on the wafer is to be imaged using the alignment detection system in the exposure apparatus in the first and second embodiments, but apparatuses other than the exposure apparatus such as an optical inspection apparatus may also be used.

<<Third Embodiment>>

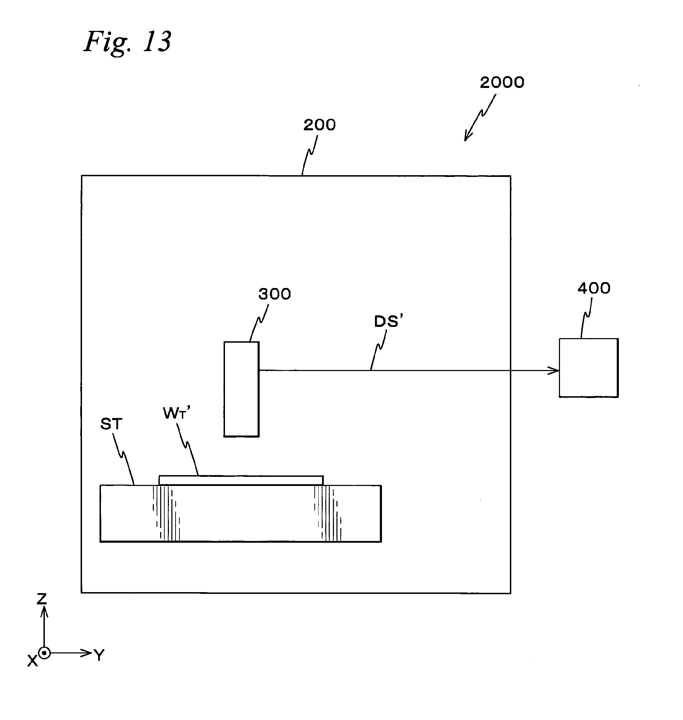

FIG. 13 shows the schematic configuration of a wafer inspection apparatus 2000, as an example of an inspection apparatus related to a third embodiment, to which a measurement method using the contrast information described above is applied. Inspection apparatus 2000 is housed in a chamber 200 and driven by a drive device (not shown), and is equipped with a stage ST that moves within a horizontal plane (an XY plane), an imaging device 300 that images a pattern (e.g. a resist pattern) on wafer $W_T$' held on stage ST via a vacuum chuck (not shown) or the like, and an arithmetic processor 400 that includes a microcomputer and the like to which imaging data DS' by imaging device 300 is supplied. Arithmetic processor 400 also performs the control of the drive device described above.

Wafer $W_T$' is assumed to be a wafer to which an image of measurement pattern MP' in FIG. 10 described above is transferred in the similar procedures to those in the first embodiment by exposure apparatus 100 of the first embodiment and to which the development processing is applied.

Wafer $W_T'$ is made in the following procedures a. and b.

   a. First of all, main controller 28 performs the processing similar to those in steps 402 to 420 to a substrate (which is to be wafer W) that becomes wafer $W_T'$ in exposure apparatus 100. With this operation, latent images of evaluation-point-corresponding areas $DB_1$ to $DB_5$ are formed on a resist layer on the wafer W surface in the placement similar to that shown in FIG. 6. In each of the divided areas in this case, however, an image of measurement pattern MP' shown in FIG. 10 is formed.
   b. Next, the wafer W is developed by a coater/developer (C/D) (not shown). With the development, the making of wafer $W_T'$ ends.

In this case, the linewidth (or pitch) of each of a plurality of lines that constitute each line pattern of the measurement pattern image formed on wafer $W_T'$ is preferably less than or equal to around four times (e.g. 320nm in this example) the resolution limit (e.g. 80nm in this example) of exposure apparatus 100, which is similar to the first embodiment. Incidentally, in order to perform measurement with high sensitivity, the linewidth (or pitch) of each of the plurality of lines is preferably less than or equal to around three times (240nm in this example) the resolution limit of exposure apparatus 100, and the linewidth (or pitch) is 80nm in this embodiment.

Then, this wafer $W_T'$ is carried to the outside of the C/D by a carriage system, and is loaded into chamber 200 of inspection apparatus 2000 by an operator (or a robot or the like), and then mounted on stage ST by a carriage system inside chamber 200.

Imaging device 300 of inspection apparatus 2000 is, for example, an inspection optical system equipped with an optical system that has a field capable of simultaneously imaging the entire area of each evaluation-point-corresponding area $DB_n$, and has the resolution limit that is more than a quarter of the resolution limit (80nm in this example) of exposure apparatus 100 (i.e. has the lower resolution), as is described above. In this embodiment, since a quarter of the resolution limit (80nm) of exposure apparatus 100 is 320nm, the resolution limit of inspection apparatus 2000 (the detection resolution of imaging device 300) is assumed to be larger than 320nm, for example, to be 350nm. Incidentally, because the measurement pattern image has a linewidth of 400nm (the pitch is 800nm), inspection apparatus 2000 can resolve (detect) the measurement pattern image.

In inspection apparatus 2000, arithmetic processor 400 computes the best focus position of projection optical system PL of exposure apparatus 100 by performing the processing in the procedures similar to steps 502 to 518 described above.

Also in this case, strict focusing as in the case of using the SEM becomes unnecessary and the measurement time can be shortened, as in the first embodiment described above. For example, even in the case where each evaluation-point-corresponding area $DB_n$ is not imaged simultaneously as in the above description, but the imaging is performed per divided area $DA_i$ or per plurality of the divided areas as a unit, the measurement time per imaging can be shortened. Further, the measurement can be performed regardless of the types of pattern images (such as a line-and-space (an isolated line, a dense line), a contact hole, the size and the disposed direction), and regardless of illumination conditions when generating a projected image (a pattern image) of measurement pattern $MP_n$. Further, also in this case, in the similar manner to the case described above, information on the luminance value of each pixel concerning each measurement mark area (or each divided area) that does not include the deviation described above, for example, a kind of statistic and the like related to the luminance value of each pixel, such as the total value or the average value of the luminance values of the respective pixels within an area having a predetermined area size (a predetermined number of pixels) including the measurement pattern image out of the measurement mark area (or the divided area) may also be employed as the contrast information. The point is that in the case where the area size (such as the number of pixels) of the imaging area that is used for computation of the contrast information is made to be constant for each measurement mark area (or each divided area), any statistic related to the luminance value of each pixel may be used. Incidentally, also in the third embodiment, as in the first embodiment, step pitch SP of wafer $W_T$ when transferring the measurement pattern may be more than the size of a projected image of each aperture pattern $AP_n$ on wafer $W_T$.

Further, in the third embodiment, because measurement pattern MP' in FIG. 10 is used, "contrast change" in accordance with the focus change increase, and therefore the best focus position can be detected with high sensitivity.

Further, in the third embodiment, the case has been described where the exposure condition that is changed when transferring the measurement pattern is the focus position, that is, the position of the wafer in the optical axis direction of projection optical system PL, but the present invention is not limited thereto. Besides the focus position, the exposure condition may include at least one of setting conditions of all the constituents related to exposure or the like, such as an exposure dose, an illumination condition (including a type of mask) when generating a pattern image, and the image-forming characteristics of projection optical system PL. Incidentally, the exposure condition in the first embodiment described above is not limited to the focus position either.

For example, a plurality of pattern images that are severally formed on a substrate under the different exposure conditions (such as an exposure dose or illumination condition) via an optical system (such as projection optical system PL) are detected by imaging device 300, contrast information of the pattern images is computed by arithmetic processor 400 using imaging data of the plurality of pattern images by imaging device 300, and also the proper value of the exposure condition (such as the optimal exposure dose or illumination condition) can be obtained based on the contrast information.

Accordingly, in inspection apparatus 2000, the determination of pattern information as will be described below can also be performed. That is, for example, in the case where a detection sample similar to wafer $W_T$' described above is mounted on stage ST, imaging device 300 (the inspection optical system) detects, under the control of arithmetic processor 400, brightness/darkness information of each pattern area included in a pattern group in which a plurality of pattern areas each including a periodic pattern which is less than or equal to the resolution limit of imaging device 300 are formed. Then, arithmetic processor 400 determines, for example, the pattern area where the change in the detected brightness/darkness information (i.e. the contrast value) becomes maximum from among the pattern group. Herein, in the case where the contrast values in the plurality of pattern areas change in a mountain shape as indicated by a solid line in FIG. 9, for example, in accordance with the change in a predetermined pattern forming condition (the exposure condition described above) and also the contrast value corresponding the peak of the mountain cannot be acquired, arithmetic processor 400 plots the contrast value of each pattern area on a two-dimensional coordinate system having a horizontal axis showing the pattern forming condition and a vertical axis showing the contrast value, and draws a contrast curve by performing curve fitting of the plot points with the approximate curve, and for example, may compute by interpolation the proper value of the pattern forming condition, for example, the optimal value (the peak of the contrast curve). Also in this case, as an example, the average value of values at two intersecting points of the contrast curve with a predetermined slice level may be assumed to be the proper value of the pattern forming condition described above, for example, the optimal value.

Incidentally, in the third embodiment described above, the wafer inspection apparatus is described as an example, but the inspection apparatus of the present invention includes a mask inspection apparatus, a linewidth measurement apparatus (including an overlay measurement apparatus and the like) in the broader sense, and the like. Further, in the third embodiment described above, inspection apparatus 2000 is to be arranged independently from the coater/developer (C/D) or the like, but the present invention is not limited thereto, and for example, inspection apparatus 2000 may also be inline connected to the C/D, or may be incorporated in the C/D or the exposure apparatus. Moreover, in the third embodiment described above, arithmetic processor 400 transmits its determination results to the exposure apparatus (100, 1000) via a network (wireless or wired) such as LAN, and main controller 28 may also perform the setting of the exposure conditions or the like based on the transmitted determination results. Or, the determination results by arithmetic processor 400 are transmitted to a host computer that performs the control and the like of a plurality of device manufacturing apparatuses (including the exposure apparatus and the like) within a device manufacturing plant (a clean room), and the exposure apparatus (main controller 28) may also perform the setting of the exposure conditions and the like according to instructions of the host computer.

Incidentally, in each of the embodiments described above, the pattern images on the wafer are to be detected using the measurement apparatus (alignment detection system AS, inspection apparatus 2000) by the imaging method, but the photodetection device (the sensor) of the measurement apparatus is not limited to the imaging device such as CCD, and may also include a line sensor, for example. In this case, the line sensor may be one dimensional, but the line sensors that are two-dimensionally placed are preferably used. Accordingly, data used in the computation of the contrast information described above (the measurement results of pattern images by the measurement apparatus) is not limited to the imaging data. Moreover, in each of the embodiments described above, in the computation of the statistic (the contrast information, the brightness/darkness information) described above, the average value of the luminance values of a plurality of pixels (or the luminance value of a single pixel) in the area where no measurement pattern exists within at least one divided area (or measurement mark area) on the wafer is to be used as a predetermined reference value, but the predetermined reference value is not limited thereto. For example, the luminance value (including the average value) concerning the area other than the divided area (or the measurement mark area) or the average value or the like of the luminance values concerning the divided area (or the measurement mark area) may also be used. Further, the statistic that does not include the above-described deviation may be used as the contrast information as is described above, but for example, in the case where the linewidth (or pitch) of the measurement pattern image is nearly equal or close to the resolution limit of the measurement apparatus (the detection resolution of the optical system), it becomes difficult for the measurement apparatus to sensitively detect the change in the linewidth of the measurement pattern image, and therefore it is preferable that the statistic, with which the above-described deviation can be obtained assuming the luminance value (or the average value) of the area where the measurement pattern image does not exist as the predetermined reference value, is used as the contrast information. In this case, since the slight offset change that is obtained from the entirety of each L/S pattern of the measurement pattern image is taken into consideration as the contrast value, the measurement accuracy can be improved.

Further, in each of the embodiments described above, positional information of wafer stage WST is to be measured using the interferometer system (26), but the present invention is not limited thereto, and for example, an encoder system that detects a scale (a diffraction grating) arranged on the upper surface of wafer stage WST may also used. In this case, it is preferable that a hybrid system that is equipped with both the interferometer system and the encoder system is employed and calibration of measurement results of the encoder system is performed using measurement results of the interferometer system. Further, the position control of the wafer stage may also be performed by switching the interferometer system and the encoder system to be used, or using both the systems.

Further, in the embodiments such as the first embodiment, the best focus position, the field of curvature, or astigmatism is to be obtained as the optical characteristics of the projection optical system, but the optical characteristics are not limited thereto and may be another aberration. Furthermore, the exposure apparatus of the first and second embodiments described above is not limited to the apparatus for manufacturing semiconductor devices, but may also be exposure apparatuses such as an exposure apparatus used when manufacturing other devices, for example, displays (such as liquid crystal display devices), imaging devices (such CCDs), thin film magnetic heads, micromachines, DNA chips or the like, and the present invention may also be applied to theses exposure apparatuses.

Incidentally, in the first and second embodiments described above, a transmissive type mask, which is a transmissive substrate on which a predetermined light shielding pattern (or a phase pattern or a light attenuation pattern) is formed, is used, but instead of this mask, as is disclosed in, for example, U.S. Patent No. 6,778,257, an electron mask (which is also called a variable shaped mask, and includes, for example, a DMD (Digital Micromirror Device) that is a type of a non-emission type image display device (spatial light modulator) or the like) on which a light-transmitting pattern, a reflection pattern, or an emission pattern is formed according to electronic data of the pattern that is to be exposed may also be used. Further, the projection optical system is not limited to a dioptric system, but may also be either a catadioptric system or a catoptric system, and the magnification is not limited to the reduction system but may be either an equal magnifying system or a magnifying system. In addition, the projected image by the projection optical system may be either an inverted image or an upright image. Further, the present invention can also be applied to an exposure apparatus (a lithography system) that forms device patterns on wafer W by forming interference fringes on wafer W, as is disclosed in the pamphlet of International Publication No. WO 2001/035168. Moreover, the present invention can also be applied to an exposure apparatus that synthesizes two reticle patterns on a wafer via a projection optical system and almost simultaneously performs double exposure of one shot area on the wafer by one scanning exposure, as is disclosed in, for example, Kohyo (published Japanese translation of International Publication for Patent Application) No. 2004-519850 (the corresponding U.S. Patent No. 6, 611, 316) . The point is that the present invention can be applied to any exposure apparatus that exposes an object by generating a measurement pattern image within an exposure area of an optical system.

Incidentally, in each of the embodiments described above, a sensitive object (substrate) subject to exposure to which an energy beam (such as illumination light IL) is irradiated is not limited to a wafer, but may be other objects such as a glass plate, a ceramic substrate, or a mask blank, and the shape of the object is not limited to a circular shape but may also be a rectangular shape.

Further, as long as the national laws in designated states (or elected states), to which this international application is applied, permit, the above disclosures of all the Kokai and Kohyo publications, the U.S. Patents, the U.S. Application Publications and the European Patent Application Publication cited in each of the embodiments above and the modified examples are each incorporated herein by reference.

Semiconductor devices are manufactured through the following steps: a step where the function/performance design of a device is performed; a step where a reticle based on the design step is manufactured; a step where a wafer is manufactured using materials such as silicon; a lithography step where a pattern of the reticle is transferred onto the wafer by the exposure apparatus of the first or second embodiment described above executing the exposure method described above; a device assembly step (including a dicing process, a bonding process, and a packaging process); an inspection step; and the like. In this case, in the lithography step, the exposure method described above is executed using the exposure apparatus of the first or second embodiment and device patterns are formed on the wafer, and therefore, highly-integrated devices can be manufactured with high productivity.

The optical characteristics measurement method of the present invention is suitable for measurement of optical characteristics of an optical system that generates a pattern image on a predetermined surface such as a projection optical system of a projection exposure apparatus. Further, the exposure method and the device manufacturing method of the present invention are suitable for manufacturing of microdevices. The inspection apparatus, the measurement method, and the best focus position measurement method of the present invention are suitable to obtain the proper values of exposure conditions. Furthermore, the pattern information determining method of the present invention is suitable to determine information shown by the forming state of patterns formed on a sample such as a wafer.

## Claims

1. An optical characteristics measurement method of measuring an optical characteristic of an optical system that generates a pattern image on a predetermined surface, the method comprising:

a first process of sequentially exposing a plurality of divided areas on an object that is placed on the predetermined surface side of the optical system, by generating a measurement pattern image within an exposure area of the optical system while changing the position of the object in an optical axis direction of the optical system;
a second process of imaging the plurality of divided areas on the object; and
a third process of computing a predetermined statistic related to a luminance value of each pixel for each of the divided areas by processing imaging data obtained by the imaging, and also obtaining an optical characteristic of the optical system based on the computed statistic regarding each of the divided areas.

2. The optical characteristics measurement method according to Claim 1, wherein
the predetermined statistic is a statistic that includes the deviation of a luminance value of each pixel with respect to a predetermined reference value regarding each of the divided areas.

3. The optical characteristics measurement method according to Claim 2, wherein
the predetermined reference value is either a luminance value of a single pixel of an area where the pattern image does not exist inside at least one of the divided areas on the object or an average value of luminance values of a plurality of pixels of the area.

4. The optical characteristics measurement method according to Claim 1, wherein
the predetermined statistic is at least one of the variance and the standard deviation of a luminance value of each pixel regarding each of the divided areas.

5. The optical characteristics measurement method according to Claim 1, wherein
in the first process, at least one area having a rectangular shape as a whole that is composed of a plurality of adjacent divided areas is formed on the object by sequentially moving the object in a predetermined direction orthogonal to the optical axis direction so that the plurality of divided areas on the object can be simultaneously imaged in at least the predetermined direction in the second process.

6. The optical characteristics measurement method according to Claim 1, wherein
in the first process, the object is moved in a step pitch, which is less than or equal to a distance corresponding to a size of the divide area where the pattern image is generated within the exposure area, in at least a predetermined direction orthogonal to the optical axis direction.

7. The optical characteristics measurement method according to Claim 6, wherein
a photosensitive layer is formed with a positive type photoresist on the surface of the object, and also an image that is subject to imaging is formed in each of the divided areas on the object through development processing after the first process, and
the step pitch is set so that the photosensitive layer between adjacent images on the object is removed by the development processing.

8. The optical characteristics measurement method according to Claim 1, wherein
the optical characteristic includes a best focus position at a measurement point within the exposure area of the optical system.

9. The optical characteristics measurement method according to Claim 1, wherein
in the first process, the plurality of divided areas on the object are sequentially exposed by generating a measurement pattern image at a plurality of positions within the exposure area of the optical system while changing the position of the object in the optical axis direction of the optical system.

10. An exposure method, comprising:

a process of measuring an optical characteristic of an optical system using the optical characteristics measurement method according to any one of Claims 1 to 9; and
a process of exposing an object by generating a predetermined pattern image within an exposure area of the optical system, taking a measurement result of the optical characteristic into consideration.

11. A device manufacturing method, including:

a lithography process of exposing an object by the exposure method according to Claim 10.

12. An optical characteristics measurement method of measuring an optical characteristic of an optical system that is used in an exposure apparatus that generates a pattern image on an object via the optical system and liquid, the method comprising:

a first process of sequentially exposing a plurality of divided areas on the object, by sequentially moving the object in a predetermined step pitch long enough to keep temperature variation of the liquid caused by exposure of a previous shot area from affecting exposure of a next shot area, and generating a measurement pattern image within an exposure area of the optical system, while changing at least one exposure condition; a second process of detecting a forming state of the measurement pattern image in the plurality of divided areas on the object; and a third process of obtaining an optical characteristic of the optical system based on a result of the detection.

13. An exposure method, comprising:

a process of measuring an optical characteristic of the optical system using the optical characteristics measurement method according to Claim 12; and a process of exposing the object with a predetermined pattern image formed via the optical system and liquid, taking a measurement result of the optical characteristic into consideration.

14. A device manufacturing method, including:

a lithography process of exposing an object by the exposure method according to Claim 13.

15. An inspection apparatus that detects a plurality of pattern images that are formed on a substrate via an optical system respectively under a different exposure condition, the apparatus comprising:

an imaging device that has a field capable of simultaneously imaging the plurality of pattern images; and a processor that computes contrast information of the plurality of pattern images using imaging data of the plurality of pattern images by the imaging device and also obtains a proper value of the exposure condition based on the contrast information.

16. The inspection apparatus according to Claim 15, wherein the exposure condition includes an optical characteristic of the optical system.

17. The inspection apparatus according to Claim 15, wherein the processor normalizes an output related to a pixel from the imaging device when computing the contrast information.

18. The inspection apparatus according to Claim 17, wherein the processor normalizes the output related to a pixel from the imaging device using a predetermined reference value.

19. The inspection apparatus according to Claim 18, wherein the predetermined reference value is either a luminance value of a single pixel of an area where the pattern image does not exist on the substrate or an average value of luminance values of a plurality of pixels of the area.

20. The inspection apparatus according to any one of Claims 15 to 19, wherein the processor computes a predetermined statistic related to a luminance value of each pixel regarding an area where the pattern image is formed on the substrate, as the contrast information.

21. The inspection apparatus according to Claim 20, wherein the statistic is at least one of the variance and the standard deviation.

22. A measurement method of performing a predetermined measurement by detecting a plurality of pattern images that are formed on a substrate respectively under a different exposure condition via an optical system, the method comprising:

a process of imaging the plurality of pattern images using an imaging device that has a field capable of simultaneously imaging the plurality of pattern images; and a process of computing contrast information of the plurality of pattern images using imaging data of the imaged plurality of pattern images, and also obtaining a proper value of the exposure condition based on the contrast information.

23. A best focus measurement method of a projection exposure apparatus, the method comprising:

a process of forming a plurality of images of pattern areas each including a pattern having a linewidth that is less than or equal to around four times a resolution limit of the projection exposure apparatus respectively at different positions on an object, while changing a focus position; a process of detecting brightness/darkness information of the plurality of images of pattern areas formed on the object, using an inspection optical system whose resolution limit is more than a quarter of the resolution limit of the projection exposure apparatus; and a process of computing a best focus position based on the detected brightness/darkness information.

24. The best focus measurement method according to Claim 23, wherein

a linewidth of the pattern is less than or equal to around three times the resolution limit of the projection exposure apparatus.

25. The best focus measurement method according to one of Claims 23 and 24, wherein the pattern is composed of a plurality of pattern elements having the linewidth.

26. A pattern information determining method, comprising:

a process of detecting brightness/darkness information of a pattern group, in which a plurality of pattern areas each including a periodic pattern that is less than or equal to a resolution limit of an inspection optical system are formed, using the inspection optical system; and a process of determining a pattern area with which a change in the detected brightness/darkness information becomes maximum from among the pattern group.

27. The pattern information determining method according to Claim 26, wherein the pattern group can be simultaneously detected by the inspection optical system.

28. A pattern information determining apparatus, comprising:

an inspection optical system that detects brightness/darkness information of a pattern group in which a plurality of pattern areas each including a periodic pattern are formed; and a processor that determines a pattern area with which a change in the detected brightness/darkness information becomes maximum from among the pattern group, wherein the periodic pattern is less than or equal to a resolution limit of the inspection optical system.

*Fig. 1*

*Fig. 2*

*Fig. 3*

## *Fig. 4*

```
          ( START )          402

     LOAD RETICLE R_T AND WAFER W_T

      PREPARATORY OPERATIONS        404
      SUCH AS RETICLE ALIGNMENT

        SET A TARGET VALUE OF       406
       EXPOSURE ENERGY AMOUNT
        TO THE OPTIMAL VALUE

            i ← 1                   408

    MOVE THE WAFER TO A TARGET POSITION Zi    410
      IN Z-AXIS DIRECTION AND ALSO MOVE
         THE WAFER WITHIN XY PLANE AND
      TRASNFER A MEASUREMENT PATTERN
            TO DIVIDED AREA DA_i

                                          i ← i + 1    418

         EXPOSURE IN               416
   PREDETERMINED Z RANGE ENDS         N
          (i ≧ M)?

            Y

        UNLOAD WAFER W_T            420

     N  DEVELOPMENT ENDS?           422

            Y

         LOAD WAFER W_T             424

     COMPUTE OPTICAL CHARACTERISTICS    426

            ( END )
```

*Fig. 5*

*Fig. 6*

EP 1 950 794 A1

*Fig. 7*

*Fig. 8*

426

START

POSITION SETTING TO EVALUATION-POINT-CORRESPONDING AREA $DB_n$ ～502

CAPTURE IMAGING DATA ～504

CREATE IMAGING DATA FILE ～506

DETECT THE OUTER EDGE OF EVALUATION-POINT-CORRESPONDING AREA $DB_n$ ～508

COMPUTE EACH DIVIDED AREA WITH REFERENCE TO THE OUTER EDGE ～510

COMPUTE THE CONTRAST VALUE PER MEASUREMENT MARK AREA OF EACH DIVIDED AREA ～512

COMPUTE THE BEST FOCUS POSITION ～514

518

$n \leftarrow n+1$

PROCESSING OF ALL EVALUATION-POINT-CORRESPONDING AREAS ENDS? 516

N

Y

COMPUTE OPTICAL CHARACTERISTICS 520

RETURN

## Fig. 9

*Fig. 10*

*Fig. 11*

1000

IOP

IL

RST    R    12    14

AXp

MAIN
CONTROLLER

28

PU

40

AS    DS    16

PLL { PL
      Lq

132    191

131B    131A    24    26

WST / 18

20    W    P    22

Z

X ⊙ → Y

*Fig. 12*

*Fig. 13*

## INTERNATIONAL SEARCH REPORT

International application No.

PCT/JP2006/320232

A. CLASSIFICATION OF SUBJECT MATTER
*H01L21/027*(2006.01)i, *G03F7/207*(2006.01)i

According to International Patent Classification (IPC) or to both national classification and IPC

B. FIELDS SEARCHED

Minimum documentation searched (classification system followed by classification symbols)
H01L21/027, G03F7/207

Documentation searched other than minimum documentation to the extent that such documents are included in the fields searched
Jitsuyo Shinan Koho         1922-1996    Jitsuyo Shinan Toroku Koho   1996-2006
Kokai Jitsuyo Shinan Koho   1971-2006    Toroku Jitsuyo Shinan Koho   1994-2006

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | JP 2004-146702 A  (Nikon Corp.),<br>20 May, 2004 (20.05.04),<br>Full text; particularly, Par. Nos. [0096],<br>[0104], [0139], [0189] to [0213], [0234],<br>[0268] to [0273], [0281] to [0283]<br>(Family: none) | 1-11,15-28<br>12-14 |
| Y | JP 10-303114 A  (Nikon Corp.),<br>13 November, 1998 (13.11.98),<br>Full text; particularly, Par. No. [0003]<br>(Family: none) | 12-14 |
| A | JP 2004-165307 A  (Nikon Corp.),<br>10 June, 2004 (10.06.04),<br>Full text; particularly, Par. No. [0171];<br>Fig. 17<br>(Family: none) | 1-11 |

☐ Further documents are listed in the continuation of Box C.     ☐ See patent family annex.

| | |
|---|---|
| * Special categories of cited documents:<br>"A" document defining the general state of the art which is not considered   to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search<br>27 November, 2006 (27.11.06) | Date of mailing of the international search report<br>05 December, 2006 (05.12.06) |
|---|---|
| Name and mailing address of the ISA/<br>Japanese Patent Office | Authorized officer |
| Facsimile No. | Telephone No. |

Form PCT/ISA/210 (second sheet) (April 2005)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 4908656 A
- JP 2001313250 A
- US 20030025890 A
- JP 6283403 A
- US 5448332 A
- JP 7176468 A
- US 5646413 A
- JP 2004146702 A
- WO 9949504 A
- WO 2004086468 A
- US 20050280791 A
- JP 2004289126 A
- US 6952253 B
- EP 1420298 A
- WO 2004055803 A
- WO 2004057590 A
- WO 2005029559 A
- US 6778257 B
- WO 2001035168 A
- JP 2004519850 A
- US 6611316 B